# EUROPÄISCHE PATENTSCHRIFT

(11) **EP 3 401 732 B1**
(45) Veröffentlichungstag und Bekanntmachung des Hinweises auf die Patenterteilung: **05.02.2020**
(21) Anmeldenummer: 17170540.3
(22) Anmeldetag: 11.05.2017
(51) Int. Cl.: G03F 7/095, G03F 7/016, G03F 7/20, G03F 7/24

(54) **HOCHAUFLÖSENDE FLEXODRUCKPLATTE UND MITTEL ZU DEREN HERSTELLUNG**
HIGH RESOLUTION FLEXOGRAPHIC PRINTING PLATE AND MEANS FOR CONSTRUCTING SAME
PLAQUE DE FLEXOGRAPHIE HAUTE DÉFINITION ET AGENT DESTINÉ À SA FABRICATION

(43) Veröffentlichungstag der Anmeldung: 14.11.2018
(73) Patentinhaber: Folex AG, 6423 Seewen (CH)
(72) Erfinder: Varescon, François, 6440 Brunnen (CH); Osenegg, Carlfried, 6403 Küssnacht am Rigi (CH); Nigg, Robert, 6442 Gersau (CH); Joho, Felix Bernhard, 6330 Cham (CH)
(74) Vertreter: Rüedi, Regula Béatrice

(56) Entgegenhaltungen:
- EP-A2- 0 797 120
- DE-A1- 2 923 980
- DE-A1- 10 338 257

## Beschreibung

### Gebiet der Erfindung

Die Erfindung betrifft Aufzeichnungselemente zur Herstellung hochauflösender Flexodruckplatten, die zur digitalen Informationsübertragung geeignet sind, sowie Mittel zu deren Herstellung und Verfahren zur Herstellung hochaufgelöster Flexodruckplatten.

### Hintergrund

Digitale Information aufzeichnungsfähige Aufzeichnungselemente sind prinzipiell bekannt. Sie bestehen - für die Herstellung herkömmlicher Flexodruckplatten - aus mindesten einem Träger, einer fotopolymerisierbaren Schicht sowie einer Schicht, die fähig ist digitale Information aufzuzeichnen (aufzeichnungsfähige Vorlageschicht).

Aus DE-OS 29 23 980 sind Mehrschichtfolien zur gleichzeitigen Herstellung eines Positivs und eines Negativs von einem Transparentbild bekannt. Diese sind aber nicht zur digitalen Informationsübertragung mit aktinischer Laserstrahlung geeignet. Sie enthalten eine obere, für UV-Licht transparente Trägerfolie, eine fotopolymerisierbare Schicht, eine zweite fotoempfindliche Schicht und eine hydrophile Trägerschicht, gemäss Beispiel ein Aluminiumblech. Die zweite fotoempfindliche Schicht, enthält als Hauptbestandteil eine Diazonium-Zusammensetzung, die infolge Bestrahlung zäh wird. Die Belichtung der Mehrschichtfolie gemäss DE-OS 29 23 980 erfolgt über eine transparente Maske. Die Diazoniumschicht bewirkt im belichteten Bereich eine Haftungsverstärkung, derart, dass beim mechanischen Trennen der Schichten ohne weitere Entwicklung die fotopolymerisierte Schicht und die damit in Kontakt stehende Diazoniumschicht auf dem hydrophilen Träger bleiben, die nicht belichteten Schichten auf dem transparenten Träger.

Andere zweischichtige strahlungsempfindliche Aufzeichnungselemente sind aus der deutschen Offenlegungsschrift DE 103 38 257 A1 bekannt. Bei den darin offenbarten Aufzeichnungselementen handelt es sich um strahlungsempfindliche Elemente, die u.a. mit Lasern, die im Wellenlängenbereich von 650 bis 1300 nm emittieren, digital bebilderbar sind. Beschrieben wird ein Zweischichtsystem, das auf einem Trägermaterial, beispielsweise einem Aluminiumträger, aufgebracht ist. Direkt auf dem Träger aufgebracht ist eine fotopolymerisierbare Schicht, die strahlungsempfindliche Verbindungen (IR-Absorber, Diazoverbindungen) enthält, und darüber, als Deckschicht, ein negativ arbeitendes Diazoharz der Formel (II) .

Bei weiteren aufzeichnungsfähigen Schichten kann es sich beispielweise um eine Schicht auf Basis eines Fotopolymers (siehe EP 0797120 A2 und EP 0913730 B1), um eine mittels Ink-Jet bedruckbare Schicht (siehe US7875321 B2), um eine thermografische Schicht (siehe DE60125755 T2, US2014370440 A1 und US2003/211423 A1), um eine Silberhalogenidemulsions-Schicht oder eine laserablatiertbare Schicht (siehe US2008258344 A1, WO2015040094 A2) handeln, wobei die Art der aufzeichnungsfähigen Schicht für die Qualität der Wiedergabe der niedrigen und hohen Tonwerte der Druckerzeugnisse verantwortlich ist.

Die für den Druck entscheidende Schicht der digitalen Flexodruckplatten ist die auf einem Träger (üblicherweise eine Folie aus Polyethylenterephthalat (PET)) angeordnete fotopolymerisierbare Schicht. In der Folge wird diese fotopolymerisierbare Schicht auch als Reliefschicht bezeichnet, da diese nach dem Auswaschprozess das endgültige Druckplattenprofil ergibt. Bei der Erstellung des Druckplattenprofils kommt der aufzeichnungsfähigen Schicht eine wichtige Rolle zu, da diese für die Auflösung des Druckplattenprofils verantwortlich ist. Diese Auflösung umfasst unter anderem die Wiedergabe der feinen Druckelemente und der niedrigen und hohen Tonwerte, insbesondere im Bereich von 0 bis 5% bzw. 95 bis 100 % der Rasterpunkte.

Die oben erwähnten Verfahren mit einer aufzeichnungsfähigen Schicht auf Basis einer Ink-Jet bedruckbaren Schicht, einer thermografischen Schicht oder einer laserablatierbaren Schicht (auch als LAMS (Laserablatierbare Maskenschichten) bezeichnet) zeigen nicht die gewünschten Druckergebnisse in Bezug auf die Wiedergabe der feinen Druckelemente und der niedrigen und hohen Tonwerte im Bereich von 0-5% und 95-100% der Rasterpunkte bei hoher Auflösung (80 Linien/cm, 4400dpi).

Die angewandten Belichtungstechnologien für die Herstellung der Druckplatten benötigen zudem zwei verschiedene Belichtungseinheiten, die ein wichtiger Kostenfaktor in der Plattenherstellung sind, und zusätzlich tritt während der Belichtungsprozesse Sauerstoffangriff auf, der bei doppelter Belichtung verstärkt wird.

Aus EP 0797120 A2 ist - wie bereits oben erwähnt - die Verwendung einer aufzeichnungsfähigen Schicht auf Basis eines Fotopolymers bekannt. Diese Schicht besteht aus einer arylazophosphonathaltigen Verbindung der Formel 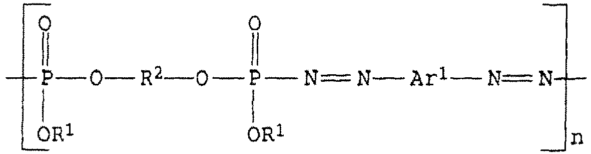 worin R¹, R², Ar¹ und n die in EP 0 797 120 A2, Seiten 5 und 6, angegebene Bedeutung haben.

Durch Belichtung mittels aktinischer Laserstrahlung erfährt die Schicht mit einer optischen Dichte im aktinischen Bereich von >2.5 an den belichteten Stellen eine Änderung der optischen Dichte um >1 unter hohen Energie-Werten von >5 bis zu 50 J/cm².

Nach Belichtung bzw. Vernetzung können die aufzeichnungsfähige Vorlageschicht und die nichtvernetzten Teile der Reliefschicht mittels eines oder mehrerer Entwickler entfernt werden.

Ein solches Aufzeichnungsmaterial soll gleiche Eigenschaften aufweisen, wie ein Aufzeichnungsmaterial gemäss Vergleichsbeispiel.

Ein Material gemäss EP 0 797 120 A2 weist die folgenden Probleme auf:
Die arylazophosphonathaltigen Verbindungen können monomere oder oligomere (n=l bis 10) Verbindungen sein. Insbesondere solche oligomere Verbindungen als Bestandteil einer ablatierbaren Schicht können nur unter Absorption hoher UV-Strahlung zerstört (<320 nm) werden. Dies benötigt den Einsatz von kostenintensiven Excimer-Lasern z.B. eines XeCl-Lasers (Wellenlänge : 308 nm).

Zusätzlich sind Schichten, die arylazophosphonathaltige Polymere enthalten, nicht stabil und altern sehr schnell.

Aufgabe der vorliegenden Erfindung war es deshalb, ein zur Herstellung von hochauflösenden Flexodruckplatten geeignetes Aufzeichnungsmaterial bereitzustellen, das für digitale Informationsübertragung geeignet ist und bei dem mindestens einer, vorzugsweise mehrere, insbesondere alle der nachfolgenden Teilaufgaben a) bis c) erfüllt ist/sind:
a) Die Auflösung der Rasterpunkte unter den niedrigen und über den hohen Tonwerten im Bereich von 0-5% und/oder 95-100% wird deutlich verbessert. Diese übertrifft die Auflösung, welche mit den Ende 2016 bekannten, beispielsweise von Dupont unter der Bezeichnung Cyrel® Now vertriebenen Platten erhältlich ist, die konventionelle Silberhalogenidverfahren verwenden, oder laserablatierbare (LAMS) Schichten, wie nyloflex® ACE 170 Digital von Flint, CYREL® DSP von Dupont oder Digital LUX-ITP von Mac Dermid.
b) Die Bebilderungs- und Vernetzungsprozesse werden zeitlich verkürzt.
c) Der Sauerstoffangriff während des Belichtungsverfahrens wird vermindert, wobei kein zusätzliches Hilfsmittel, wie Stickstoffatmosphäre, benötigt wird.
d) Es muss kein Laser eingesetzt werden, der sehr kurzwellige Laserstrahlung (<320 nm) erzeugt.

### Darstellung der Erfindung

Überraschenderweise lassen sich eine oder mehrere der obengenannten Teilaufgaben, insbesondere alle Teilaufgaben a) bis c) lösen durch eine aufzeichnungsfähige Vorlageschicht auf Basis von gegenüber aktinischer Laserstrahlung empfindlichen Diazoniumverbindungen. Eine solche aufzeichnungsfähige Vorlageschicht kann Bestandteil eines Halbfabrikats für die Herstellung eines Aufzeichnungsmaterials sein, welches als solches oder nach Bebilderung mittels digitaler Informationsübertragung und Entwicklung auf die Reliefschicht eines Flexodruckelements auflaminiert wird, oder die aufzeichnungsfähige Vorlageschicht kann Bestandteil eines Aufzeichnungselements sein, welches alle für die Herstellung einer Flexodruckplatte erforderlichen Schichten umfasst. Bei diesen Schichten handelt es sich insbesondere um einen Träger (A), eine durch aktinische Strahlung vernetzbare herkömmliche Fotopolymer-Schicht (B),die auch als Reliefschicht bezeichnet wird, eine polymerhaltige Zwischenschicht (C) oder eine dünne Zwischenfolie (C), eine mittels digitaler Verfahren aufzeichnungsfähige Vorlageschicht (D) auf Basis von Diazoniumverbindungen und gegebenenfalls eine auf der Schicht (D) aufgebrachte Schutzfolie (El).

Insbesondere betrifft die vorliegende Erfindung in einem Aspekt ein Aufzeichungselement, das zur Herstellung von hochauflösenden Flexodruckplatten durch digitale Informationsübertragung geeignet und mit aktinischer Laserstrahlung bebilderbar oder bebildert ist und welches in der genannten Reihenfolge übereinander angeordnet die folgenden Schichten enthält oder daraus besteht:
**(A)** eine Trägerfolie, insbesondere eine Kunststofffolie, die optional auf der mit einer fotopolymeriserbaren Schicht/Reliefschicht versehenen Seite mit einer Haftschicht versehen sein kann,
**(B)** eine in organischen und/oder wässerigen Lösemitteln lösliche fotopolymerisierbare Schicht/Reliefschicht, die durch aktinische Strahlung vernetzbar ist,
**(C)** gegebenenfalls eine für aktinische Strahlung transparente Zwischenschicht oder eine für aktinische Strahlung transparente Zwischenfolie als Trennelement,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt oder eine bebilderte Vorlageschicht, in der die monomere Diazonium-Verbindung in mindestens einem Bereich durch aktinische Laserstrahlung zerstört ist und in mindestens einem nicht belichteten Bereich infolge Entwickelns eine erhöhte aktinische Dichte hat.

Das erfindungsgemässe Aufzeichnungselement weist vorzugsweise zusätzlich
**(E1)** eine auf der aufzeichnungsfähigen Vorlageschicht **(D)** angeordnete abziehbare Schutz- oder Deckfolie auf. Eine solche Schutz- oder Deckfolie kann aus Kunststoff oder Papier oder Verbundmaterialien sein.

In einem zweiten Aspekt betrifft die Erfindung ein Halbfabrikat für die Herstellung eines Aufzeichnungselements, wie oben beschrieben. Dieses umfasst mindestens eine Folie
**(C)** und/oder **(E1)** und/oder **(E2)** und
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt ***oder*** eine bebilderte Vorlageschicht **(Da),** in der die monomere Diazonium-Verbindung in mindestens einem Bereich durch aktinische Laserstrahlung zerstört ist und in mindestens einem nicht belichteten Bereich durch Entwickeln eine erhöhte aktinische Dichte aufweist.

Die Folie **(C)** ist eine für aktinische Strahlung transparente Zwischenschicht oder eine für aktinische Strahlung transparente Zwischenfolie und die Folie **(E1)** und/oder die Folie **(E2)** ist eine Schutz- oder Deckfolie, die gleichzeitig, wie auch eine Zwischenfolie **(C),** Trägerfunktion ausüben kann. Die Folien **(E1)** und **(E2)** können aus Kunststoff oder Papier oder Verbundmaterialien sein. Sie können für aktinische Strahlung durchlässig oder undurchlässig sein.

Ein solches Halbfabrikat kann zusammen mit einem Flexodruckelement umfassend eine Trägerfolie **(A),** eine Reliefschicht **(B),** gegebenenfalls eine Haftschicht zwischen der Reliefschicht **(B)** und der Trägerfolie **(A)** und gegebenenfalls eine abziehbare Schutz- oder Deckfolie **(E3)** auf der Reliefschicht **(B)** wie folgt zu einem Aufzeichnungselement weiterverarbeitet werden:
(i) entfernen aller gegebenenfalls vorhandener Schutz- oder Deckfolien **(E2), (E3)** von der für aktinische Strahlung transparenten Zwischenschicht **(C)** oder der für aktinische Strahlung transparenten Zwischenfolie **(C)** und von der Reliefschicht **(B),**
(ii) gegebenenfalls entfernen einer Schutz- oder Deckfolie **(E1)** auf der aufzeichnungsfähigen Vorlageschicht **(D),**
(iii) gegebenenfalls bebildern der aufzeichnungsfähigen Vorlageschicht **(D)** durch belichten und entwickeln,
(iv) transferieren und laminieren der aufzeichnungsfähigen oder bebilderten Vorlageschicht **(Da)** auf der für aktinische Strahlung transparenten Zwischenschicht **(C)** oder auf der für aktinische Strahlung transparenten Zwischenfolie **(C)** auf die Reliefschicht **(B)** des Flexodruckelements ***oder*** entfernen der für aktinische Strahlung transparenten Zwischenschicht **(C)** oder der für aktinische Strahlung transparenten Zwischenfolie **(C)** und transferieren und laminieren der bebilderten Vorlageschicht **(D)** auf die Reliefschicht **(B)** des Flexodruckelements.

Eine auf dem Flexodruckelement gegebenenfalls vorhandene Schutz- oder Deckfolie **(E3)** kann - wie die Schutz- oder Deckfolien (E1), (E2) - ebenfalls aus Kunststoff oder Papier oder Verbundmaterialien sein.

Ebenfalls Gegenstand der vorliegenden Erfindung ist ein Verfahren zur Herstellung hochauflösender Flexodruckplatten unter Verwendung eines erfindungsgemässen Aufzeichnungselements und dessen Bebilderung mittels digitaler Informationsübertragung unter Verwendung aktinischer Laserstrahlung. Dieses Verfahren umfasst die folgenden Verfahrensschritte:
**(1)** gegebenenfalls **abziehen** der Deckfolie **(E1)**,
**(2) belichten** der aufzeichnungsfähigen Vorlageschicht **(D)** mittels aktinischer Laserstrahlung unter Bildung einer belichteten Vorlageschicht,
**(3) entwickeln** der belichteten Vorlageschicht **(D)** unter Bildung einer bebilderten Vorlageschicht **(Da),**
**(4) belichten** des mit der bebilderten Vorlageschicht **(Da)** versehenen Aufzeichnungselements mit aktinischer Strahlung durch die bebilderte Vorlageschicht **(Da)** hindurch.
**(5) entfernen** der Vorlageschicht **(Da),** der gegebenenfalls vorhandenen Zwischenschicht **(C)** sowie der nicht polymerisierten Anteile der reliefbildenden Schicht **(B)** unter Bildung der Flexodruckplatte,
**(6) trocknen** der erhaltenen Flexodruckplatte und
**(7)** gegebenenfalls und vorzugsweise nachbehandeln der Flexodruckplatte mit UV-Licht.

Die Flexodruckplatte kann auch ausgehend von einem erfinderischen Halbfabrikat zusammen mit einem Flexodruckelement umfassend eine Reliefschicht **(B),** eine Trägerfolie **(A)** und gegebenenfalls eine Haftschicht zwischen der Reliefschicht **(B)** und der Trägerfolie **(A),** durch Bebilderung mittels digitaler Informationsübertragung unter Verwendung aktinischer Laserstrahlung hergestellt werden. Ein solches Verfahren umfasst die Schritte:
**(i)** gegebenenfalls **abziehen** der Deckfolie **(E1)** vom Halbfabrikat,
**(ii) belichten** der aufzeichnungsfähigen Vorlageschicht **(D)** auf der für aktinische Strahlung transparenten Zwischenschicht oder der für aktinische Strahlung transparenten Zwischenfolie **(C)** mittels aktinischer Laserstrahlung unter Bildung einer belichteten Vorlageschicht **(D),**
**(iii) entwickeln** der belichteten Vorlageschicht **(D)** unter Bildung einer bebilderten Vorlageschicht **(Da),**
**(iv)** gegebenenfalls **abziehen** einer allenfalls vorhandenen Schutz- oder Deckfolie **(E2)** auf der transparenten Zwischenschicht oder Zwischenfolie **(C),**
**(v) übertragen und laminieren** der bebilderten Vorlageschicht **(Da)** auf der transparenten Zwischenschicht oder Zwischenfolie **(C) *oder*** der bebilderten Vorlageschicht **(Da)** auf die Reliefschicht **(B)** eines Flexodruckelements umfassend diese Reliefschicht **(B),** eine Trägerfolie **(A)** und gegebenenfalls eine Haftschicht zwischen der Reliefschicht **(B)** und der Trägerfolie **(A),** unter Bildung eines bebilderten Aufzeichnungselements,
**(vi) belichten** des bebilderten Aufzeichnungselements mit aktinischer Strahlung durch die bebilderte Vorlageschicht **(Da)** hindurch.
**(vii) entfernen** der bebilderten Vorlageschicht **(Da),** gegebenenfalls der Zwischenschicht oder Zwischenfolie **(C)** und der nicht polymerisierten Anteile der Reliefschicht **(B)** unter Verwendung eines Auswaschmittels, welches Wasser und/oder organische Lösungsmitteln umfasst, unter Bildung der Flexodruckplatte,
**(viii) trocknen** der erhaltenen Flexodruckplatte
**(ix)** gegebenenfalls und vorzugsweise nachbehandeln der Flexodruckplatte mit UV-Licht.

### Kurze Beschreibung der Zeichnungen

Weitere Ausgestaltungen, Vorteile und Anwendungen der Erfindung ergeben sich aus den abhängigen Ansprüchen und aus der
**Figur,** die 4 Fälle unterscheidet, nämlich
**1. Fall** die Herstellung einer Flexodruckplatte ausgehend von einem Halbfabrikat mit Zwischenfolie (C) ;
**2. Fall** die Herstellung einer Flexodruckplatte ausgehend von einem Halbfabrikat mit Zwischenschicht (C) und Schutzfolie (E1), die gleichzeitig als Trägerfolie dient;
**3. Fall** die Herstellung einer Flexodruckplatte ausgehend von einem Halbfabrikat mit Zwischenfolie (C) bei dem die belichtete und entwickelte Vorlageschicht (Da) alleine, d.h. ohne Zwischenfolie oder Zwischenschicht (C) auf die Reliefschicht eines Flexodruckelements übertragen wird, und
**4. Fall** die Herstellung einer Flexodruckplatte ausgehend von einem Halbfabrikat mit Zwischen- oder Schutz-/Deckfolie (C/El) bei dem die belichtete und entwickelte Vorlageschicht (Da), mit der Schutz-/(Zwischen)folie auf die Reliefschicht eines Flexodruckelements (Schicht (Da) auf Schicht (B)) übertragen wird. Die für aktinische Strahlung transparente Folie (C/El) kann während des Belichtungsvorgangs auf der Schicht (Da) verbleiben und nach der Fotopolymerisation zusammen mit der Schicht (Da) oder alleine vor dem Auswaschen der Schicht (B) und gegebenenfalls der Schicht (Da) abgezogen werden.

### Wege zur Ausführung der Erfindung

Das erfindungsgemässe, zur Herstellung von hochauflösenden Flexodruckplatten durch digitale Informationsübertragung geeignete mit aktinischer Laserstrahlung bebilderbare oder bebilderte Aufzeichnungselement enthält die oder besteht aus den folgenden Schichten, die in der genannten Reihenfolge übereinander angeordnet sind:
**(A)** eine Trägerfolie, die optional auf der mit einer fotopolymeriserbaren Schicht/Reliefschicht versehenen Seite mit einer Haftschicht versehen sein kann,
**(B)** eine in organischen und/oder wässerigen Lösemitteln lösliche fotopolymerisierbare Schicht/Reliefschicht, die durch aktinische Strahlung vernetzbar ist,
**(C)** gegebenenfalls und vorzugsweise eine für aktinische Strahlung transparente Zwischenschicht oder eine für aktinische Strahlung transparente Zwischenfolie als Trennelement,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt oder
**(Da)** eine bebildert Vorlageschicht, in der die monomere Diazonium-Verbindung in mindestens einem Bereich durch aktinische Laserstrahlung zerstört ist und in mindestens einem nicht belichteten Bereich infolge Entwickelns eine erhöhte aktinische Dichte hat. Vorzugsweise umfasst das Aufzeichnungselement zum Schutz gegen Verschmutzung auf der aufzeichnungsfähigen Vorlageschicht **(D)** zusätzlich
**(E1)** eine abziehbare Schutz- oder Deckfolie. Zweck der aufzeichnungsfähigen Schicht **(D)** ist deren Bebilderung mittels Laserstrahlung und anschliessendem Entwicklungsprozess unter Bildung einer Vorlage (Maske) für die aktinische Bestrahlung der Schicht **(B)** mit dem angestrebt hohen Auflösungsvermögen. Die Auflösung der Vorlageschicht **(C)** liegt im Molekularbereich.

Die aufzeichnungsfähige Vorlageschicht **(D)** weist üblicherweise eine Schichtdicke von 1 µm bis 50 µm auf, vorzugsweise von 3 µm bis 30 µm, und kann mit aktinischer Laserstrahlung einer Leistung von vorzugsweise 10 bis 1500 mJ/cm² im Spektralbereich von 330 nm bis 430 nm, insbesondere von 50 bis 1000 mJ/cm² im angegebenen Spektralbereich, belichtet werden.

Bevorzugt ist eine aufzeichnungsfähige Vorlageschicht **(D),** die mittels alkalischer Lösung oder alkalischer Dämpfe, wie mittels Ammoniak, insbesondere Ammoniak-Dampf, entwickelt werden kann. Infolge des Entwickelns werden die nicht belichteten Bereiche für die zur Vernetzung der Reliefschicht geeignete aktinische Strahlung weniger durchlässig. Gut geeignet sind Materialien, deren nicht belichtete Bereiche nach Entwickeln eine Differenz in der aktinischen Dichte > 3.0 aufweisen.

Bevorzugte aufzeichnungsfähige Vorlageschichten bestehen zu mindestens 70 Gew.-%, vorzugsweise zu mindestens 85 Gew.-% aus einem Gemisch aus
(i) mindestens einem auf Celluloseester basierten Bindemittel, insbesondere Celluloseacetatpropionat (CAP) und/oder Celluloseacetatbutyrat (CAB), und
(ii) mindestens einer Diazoniumverbindung gemäss Formel **(I)**

   **R-N⁺**≡**N X⁻** **(I)**

   **worin R** eine substituierte oder unsubstituierte organische Gruppe, wie eine Alkyl-, Acyl-, oder aromatische Gruppe bedeutet,
   **X⁻** ein Anion ist, insbesondere ausgewählt aus der Gruppe umfassend BF₄⁻, AsF₆⁻, ClO₄⁻, SbF₆⁻, CF₃SO₃⁻, SO₄⁻, PF₆⁻ PO₄³⁻, NO₃⁻, Br⁻, Cl⁻, I⁻, F⁻, Arylsulfonat, wie p-Chlorbenzolsulfonat, Alkylsulfonat, Allylsulfonat, oder ein Metallkomplexanion, z.B. ZnCl₃⁻, SnCl₆²⁻
(iii) in Kombination mit mindestens einer reaktiven Kuppler-Verbindung.

Das Verhältnis von Bindemittel zu Diazoverbindung beträgt üblicherweise von 50 : 1 bis 1 : 2, vorzugsweise 20 : 1 bis 1 : 1 und das Verhältnis von Diazoverbindung zu Kupplerverbindung von 4 : 1 bis 1 : 4, vorzugsweise 2 : 1 bis 1 : 2.

Vorzugsweise ist **R** eine aromatische Gruppe, deren Ring unabhängig von ihrer Stellung zur Diazonium Gruppe mit den Substituenten A, B und C gemäss Formel (Ia) substituiert ist. 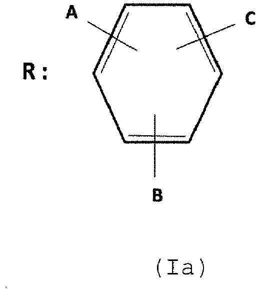 worin
A, B und C gleich oder verschieden sein können und ausgewählt sind aus der Gruppe umfassend Halogenatom, Wasserstoffatom, Aminogruppen, Thiogruppen, Nitrogruppe, Sulfogruppe, Acylreste, Carbalkoxyreste, Sulfonylreste, Cyanorest oder Carboxylrest.

Inbesondere haben die Gruppen A, B und C in ihrer bevorzugten Ortho-, Para- oder Metastellung zur Diazonium Gruppe die folgende Bedeutung:
**A** in Orthostellung zur Diazoniumgruppe ist ausgewählt aus der Gruppe umfassend Halogenatom, Wasserstoffatom, Nitrogruppe, Sulfogruppe oder organische Gruppe, wobei die organische Gruppe insbesondere ein Acyl-, Carbalkoxy-, Sulfonyl-, Cyano- oder Carboxyrest ist,
**B** in Parastellung zur Diazoniumgruppe ist ausgewählt aus
   (i) gegebenenfalls mono- oder disubstituierten Aminogruppen, wobei die Substituenten jeweils unabhängig voneinander ausgewählt sind aus der Gruppe umfassend Alkylreste, Arylreste, Alkoxyreste und Phenoxyreste, oder die beiden Substituenten bilden zusammen mit dem Stickstoff an den sie gebunden sind einen Heterozyklus, oder
   (ii) substituierten Thiogruppen, wobei der Substituent ausgewählt ist aus der Gruppe umfassend Alkylreste und Arylreste.
**C** in Meta- oder Orthostellung zur Diazoniumgruppe ist ausgewählt aus der Gruppe umfassend Acylreste, Carbalkoxyreste, Sulfonylreste, Nitroreste, Cyanoreste, Carboxylreste, Sulforeste, Wasserstoff oder Halogen.

Ein Beispiel für ein geeignetes Diazosalz ist die in den Beispielen verwendete Diazoniumverbindung (Ia) mit A: Cl, B: N(Et)₂, oder N(Me)_{2;} ;C: H, X⁻: BF₄⁻ oder PF₆⁻.

Wenn nichts anderes erwähnt ist, können alle Alkylreste und Arylreste substituiert oder unsubstituiert sein und die nachfolgend aufgeführten Gruppen/Reste haben im Rahmen dieser Erfindung die Bedeutung:
"Acylreste" sind insbesondere aliphatische Acylreste mit vorzugsweise bis zu etwa 6 Kohlenstoffatomen im Alkylrest, beispielsweise Formyl-, Acetyl-, Propionyl-, Butyryl-, β-Phenylacetyl und γ-Chlorpropionylreste oder aromatische Acylreste, wie der Benzoylrest;
"Carbalkoxyreste" sind insbesondere Alkoxycarbonylreste mit vorzugsweise 1 bis 8 Kohlenstoffatomen in der Alkoxygruppe;
"Sulfonylreste" sind insbesondere Alkylsulfonylreste, Arylsulfonylreste und Aminosulfonylreste;
"Sulforeste" sind insbesondere Alkyl- und A-rylsulforeste.

Unter "Alkylresten" sind im Rahmen der vorliegenden Erfindung vorzugsweise lineare oder verzweigtkettige, substituierte oder unsubstituierte Alkylreste mit 1 bis etwa 15 Kohlenstoffatomen in der Alkylgruppe zu verstehen, wie Methyl-, Ethyl-. Geeignete Substituenten sind insbesondere Halogenatome, wie Chloratome, Hydroxygruppen, Alkoxygruppen mit 1 bis 5 Kohlenstoffatomen, wie eine Methoxygruppe, Phenoxygruppen und/oder Benzylthiogruppen.

Unter "Arylresten" sind im Rahmen der vorliegenden Erfindung vorzugsweise substituierte und unsubstituierte mono- und polycyclische aromatische Reste mit 6 bis 10 Kohlenstoffatomen, insbesondere der Phenyl- und Naphthylrest zu verstehen. Geeignete Substituenten sind Hydroxyreste, insbesondere Alkylreste mit 1 bis 5 Kohlenstoffatomen, Alkoxyreste mit 1 bis 5 Kohlenstoffatomen und Halogenatome.

Im Rahmen dieser Erfindung als R in Formel (I) geeignete Gruppen sind z.B. beschrieben in DE OS 2 202 251 auf den Seiten 3 bis 8, und in DE 42 41 717 A1 auf S. 3, Z. 30 bis 46 und S. 4, Z. 1 bis S. 5, Z. 50.

Die mindestens eine reaktive Kuppler-Verbindung, ist insbesondere eine Kupplerverbindung der Formel (II) oder (III) 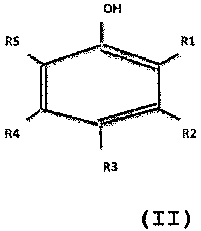
worin **R1, R2, R3, R4 und R5** gleich oder verschieden sein können und ausgewählt sind aus der Gruppe umfassend -OH, -SO₃H, -CONH-R6 (R6=Alkyl-, Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen, oder
**R1 und R2** oder **R2 und R3** zusammen einen Butadienylrest bilden, derart, dass sie zusammen mit dem Phenolring einen substituierten oder unsubstituierten aromatischen Bicyclus (Naphtolstruktur) gemäss Formel (IIa) oder (IIb) bilden 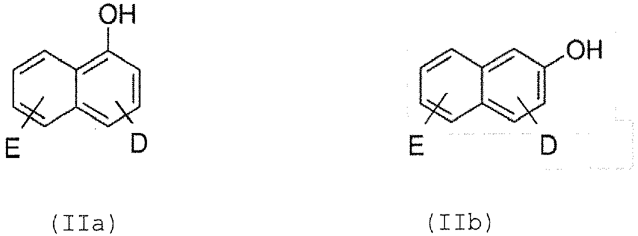
worin **D** und **E** gleich oder verschieden sein können und ausgewählt sind aus der Gruppe umfassend -OH, -SO₃H, -CONH-R6 (R6=Alkyl-,Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen,
oder
**R1** oder **R2** oder **R3** sind **-OH,** derart, dass ein unsubstituiertes und substituiertes Dihydroxybenzol gemäss Formel **(IIc), (IId) oder (IIe)** vorliegt 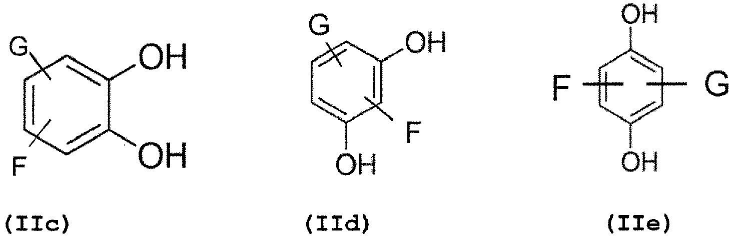 oder
**R1 = R5 = -OH** oder **R1 = R3 = -OH** oder **R2 = R4 = -OH,** derart, dass ein unsubstituiertes oder substituiertes Trihydroxybenzol gemäss Formel **(IIf), (IIg)** oder **(IIh)** vorliegt 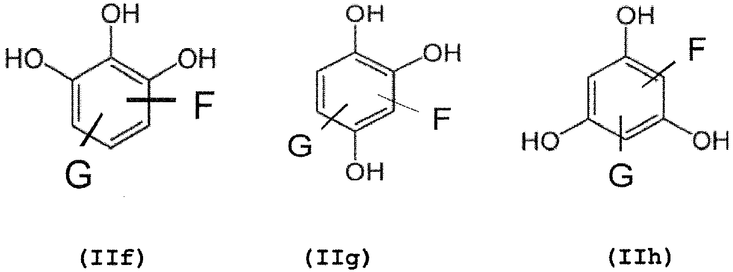 worin F und G gleich oder verschieden sein können und ausgewählt sind aus der Gruppe umfassend -OH, -SO₃H, -CONH-R6 (R6=Alkyl-,Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoffatom oder Halogen, z.B. 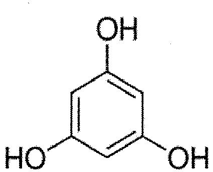 oder worin die Kupplerverbindung ein Biphenol oder Bisphenol der Formel (III) 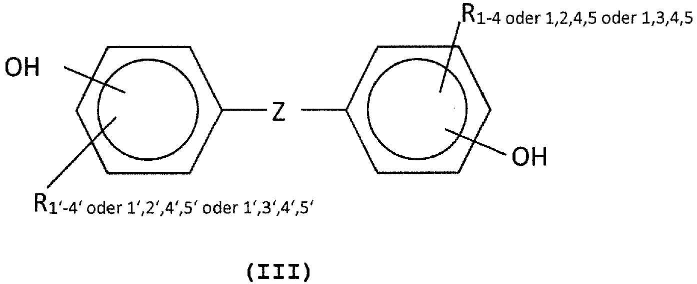 ist, mit **Z** = Bindung, -O- oder -S-, und
worin **R1,R2,R3,R4,R5 und R1',R2',R3',R4',R5'** gleich oder verschieden sein können und ausgewählt sind aus der Gruppe umfassend -OH, -SO₃H, -CONH-R6 (R6=Alkyl-, Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen, z.B. 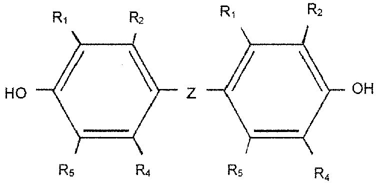 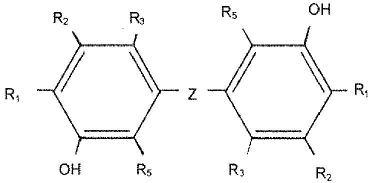 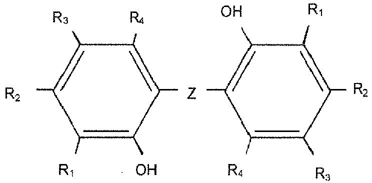 oder ein entsprechendes Bi- oder Bisphenol analog der Formel **(III),** mit je mind. 2 OH-Substituenten pro Phenylring, worin die restlichen R die oben angegebenen Bedeutung haben, z.B.

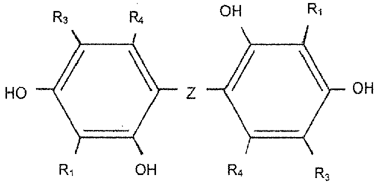

Geeignete Kupplerverbindungen sind z.B. die in den Beispielen verwendeten 3,5-Dihydroxybenzoesäure (Kupplerverbindung (IId) mit F = H und G = (HO)C=O)) und 2,2'-Biphenol (Kupplerverbindung (III) mit R1 bis R4 = H, R1' bis R4' = H und Z = Bindung).

Neben den genannten Bindemitteln, Diazoniumverbindungen und Reaktionskupplern können zur Stabilisierung der Vorlageschicht **(D)** Säuren zugesetzt werden, z.B organische Säuren, wie Zitronensäure, Oxalsäure, Sulfosalicylsäure, Ascorbinsäure, Sulfonsäure, deren pKa zwischen -4.0 und 5.0 liegt und die geeignet sind, einen pH-Wert der fertigen Beschichtungslöung unter 5.0 einzustellen (inbesondere pH unter 3.0). Um das Fliessverhalten zu verbessern könnten Benetzungsmittel, um die Flexibilität der Schicht zu erhöhen könnten Weichmacher, um die Rauhigkeit der Schichtoberfläche einzustellen könnte Mattierungsmittel, insbesondere auf Basis Silikat, Aluminat oder Polymer, wie Polymethylmethacrylat (PMMA), und um die Haftungseigenschaften der Schicht einzustellen, könnten Vernetzer, insbesondere Melaminharz, zugegeben werden.

In stark bevorzugten Ausführungsformen weist das erfindungsgemässe Aufzeichnungselement eine für aktinische Strahlung transparente Zwischenschicht **(C)** oder eine für aktinische Strahlung transparente Zwischenfolie **(C)** auf. Eine solche Zwischenfolie kann als Trägerfolie in einem Halbfabrikat dienen, die Hauptfunktion einer solchen für aktinische Strahlung transparenten Zwischenschicht **(C)** oder Zwischenfolie **(C)** ist aber das saubere Separieren der Reliefschicht **(B)** von der aufzeichnungsfähigen Vorlageschicht **(D).** Es wurde nämlich gefunden, dass die Diffusion von Monomeren und Additiven, die in der Reliefschicht **(B)** enthalten sind, die Stabilität der aufzeichnungsfähige Schicht **(D)** und deren Auflösung beeinträchtigen können.

Ein Verzicht auf die Zwischenschicht/Zwischenfolie **(C)** ist allerdings z.B. dann möglich, wenn die Vorlageschicht **(D)** bereits bebildert ist und erst kurz vor der Weiterverarbeitung zur Flexodruckplatte auf die Reliefschicht **(B)** aufgebracht wird, so dass Diffusionsvorgänge noch kaum auftreten. In einer weiteren Ausführungsform kann die für aktinische Strahlung transparente Schicht **(C)** nach Bebilderung der Vorlageschicht **(D)** die Funktion einer Schutzschicht **(E1)** auf einem Aufzeichnungselement übernehmen, wobei eine solche Schutzschicht, vor der Belichtung der Reliefschicht nicht entfernt werden muss.

Üblicherweise hat die für aktinische Strahlung transparente Zwischenschicht **(C)** oder die für aktinische Strahlung transparente Zwischenfolie **(C)** eine Dicke von bis zu 200 µm, wie 0.5 µm bis 200 µm, vorzugsweise von 1 µm bis 100 µm, insbesondere von 2 µm bis 50 µm, speziell bevorzugt von 3 µm bis 15 µm, wie 6 µm.

Die für aktinische Strahlung transparente Zwischenschicht **(C)** besteht zu mind. 70 Gew.-%, vorzugsweise zu mind. 85 Gew.-% aus mindesten einem Bindemittel, welches auf mindestens einem in Wasser und/oder organischem Lösungsmittel löslichen Polymer oder Copolymer basiert und sich durch Wasser und/oder Lösungsmittel entfernen lässt. Eine solche Zwischenschicht hat vorzugsweise eine Dicke von 3 µm bis 15 µm.

Beispiele geeigneter Polymere umfassen Polymere aus der Klasse der Polyvinylalkohole, teil- oder hochverseifte Polyvinylcarboxylate, Polyvinylacetate, Poly(ethylenoxid-vinylalcohol)-Copolymere oder Poly(ethylenoxid-vinylalcohol)-Copolymere, Polyvinylbutyral, Polyamid, Polyurethan, Polyvinylpyrrolidon, (Silicon-Polyurethan)-Copolymere, Gelatine oder Mischung derselben. Bevorzugt geeignet sind Polymere aus der Gruppe Polyvinylalkohol, Polyvinylpyrrolidon, Polyamid, Polyurethan, (Silicon-Polyurethan)-Copolymere, Gelatine und Mischung derselben. Um das Fliessverhalten zu verbessern, könnten Benetzungsmittel zugesetzt werden, um die Flexibilität der Schicht zu erhöhen könnten Weichmacher zugegeben werden.

In einer anderen Ausführungsform umfasst das Aufzeichnungselement eine für aktinische Strahlung transparente Zwischenfolie **(C),** welche sich von der Reliefschicht **(B)** mechanisch entfernen, insbesondere abziehen, lässt.

Geeignete Zwischenfolien **(C)** sind Polymerfilme mit einer Schichtdicke von 1 µm bis 50 µm, insbesondere von 2 µm bis 50 µm, wie Filme aus Polyester, wie Polyethylenterephthalat (PET), Polybutylenterephthalat (PBT), Polyethylennaphthalat (PEN)und Polymethylmethacrylat (PMMA), Polyamid oder Polycarbonat oder Polyolefine, wie Polyethylen (PE), Polypropylen (PP), Polymethylpenten (PMP) und Polybutylen (PB, PIB) oder Fluorpolymere, wie Tetrafluorethylen (PTFE), Polyvinylidenfluorid (PVDF), Ethylen-Tetrafluorethylen (ETFE), Polyvinylfluorid (PVF) und Perfluorethylenpropylen (PEP, FEP) oder Polyarylsufone, wie Polysulfon (PSU) und Polyethersulfon (PES). Geeignet sind insbesondere PET-Folien mit einer Dicke von 3 bis 15 µm.

Die dünne Zwischenfolie kann optional, in Abhängigkeit der Anwendung, mit einer üblichen haftvermittelnden Schicht behandelt sein und/oder mit einem üblichen Klebersystem ausgerüstet werden.

Die Reliefschicht **(B)** des Aufzeichnungselements hat üblicherweise eine Schichtdicke von 200 µm bis 8000 µm, insbesondere 300 µm bis 6000 µm. Sie enthält oder besteht aus einem Gemisch aus mindestens einem elastomeren Bindemittel, mindestens zwei ethylenisch ungesättigten copolymerisierbaren organischen Verbindungen (Monomere zur Bildung von beispielsweise Poly(styrol/isopren/styrol)-Blockcopolymeren) und mindestens einem Fotoinitiator oder einem Fotoinitiatorsystem sowie gegebenenfalls weiteren Hilfsstoffen, wie Weichmachern.

Handelsübliche Flexodruckelemente vom Typ **(A) + (B) + (E3),** die nach Abzug der Deckfolie (E3) als Teil des erfindungsgemässen Aufzeichnungsmaterials eingesetzt werden können, sind erhältlich von Herstellern wie Dupont, Flint, Kodak und Fuji unter deren Bezeichnung:

| | |
|---|---|
| Dupont : | Cyrel NOW |
| Flint: | Nyloflex ACE 170 |
| Kodak: | FLEXCEL NXH- oder Flexcel SR-Platte |
| Fuji: | Flenex FW |

Die Trägerfolie **(A)** des erfindungsgemässen Aufzeichnungselements hat üblicherweise eine Dicke von 50 µm bis 300 µm.

Geeignete Trägerfolien (A) sind vorzugsweise aus Kunststoff, insbesondere aus für UV-Strahlung transparentem Kunststoff, wie PET, PBT, PEN, oder Polycarbonat. Geeignet sind insbesondere PET-Folien mit einer Dicke von 50 bis 300 µm, vorzugsweise 100 bis 200 µm. Optional können die Trägerfolien (A) mit üblichen haftvermittelnden Schichten behandelt sein.

Ein weiterer Aspekt der Erfindung betrifft ein Halbfabrikat zur Herstellung eines erfindungsgemässen Aufzeichnungselements oder zur Herstellung einer Flexodruckplatte. Ein solches Halbfabrikat zeichnet sich dadurch aus, dass es
**(C)** eine für aktinische Strahlung transparente Zwischenschicht oder eine für aktinische Strahlung transparente Zwischenfolie als Trennelement und gegebenenfalls Träger,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt ***oder*** eine bebilderte Vorlageschicht **(Da),** in der die monomere Diazonium-Verbindung in mindestens einem Bereich durch aktinische Laserstrahlung zerstört ist und in mindestens einem nicht belichteten Bereich durch Entwickeln eine erhöhte aktinische Dichte aufweist,
   enthält oder daraus besteht.

In einer Ausführungsform umfasst das Halbfabrikat auf der aufzeichnungsfähigen Vorlageschicht **(D)** eine abziehbare Schutz- oder Deckfolie **(E1)**
und/oder auf der für aktinische Strahlung transparenten Zwischenschicht **(C)** oder auf der für aktinische Strahlung transparenten Zwischenfolie **(C),** insbesondere auf der Zwischenschicht **(C),** eine abziehbare Schutz- oder Deckfolie **(E2).**

Da die für aktinische Strahlung transparente Zwischenfolie, z.B. eine PET-Folie, nicht zur Verschmutzung neigt, ist deren zusätzlicher Schutz durch eine weitere Folie meist unnötig. Dagegen ist Schutz einer Zwischenschicht **(C)** durch eine Schutz- oder Deckfolie **(E2)** oft erwünscht.

Ein weiterer Aspekt der vorliegenden Erfindung ist ein Verfahren zur Herstellung eines erfindungsgemässen Aufzeichnungselements unter Verwendung eines erfindungsgemässen Halbfabrikats und eines Flexodruckelements umfassend eine Trägerfolie **(A),** eine Reliefschicht **(B),** gegebenenfalls eine Haftschicht zwischen der Reliefschicht **(B)** und der Trägerfolie **(A)** und gegebenenfalls eine abziehbare Schutz- oder Deckfolie **(E3)** auf der Reliefschicht **(B).** Das Verfahren umfasst die folgenden Schritte:
(i) entfernen der gegebenenfalls vorhandenen Schutz- oder Deckfolien **(E2), (E3)** von der für aktinische Strahlung transparenten Zwischenschicht **(C)** oder der für aktinische Strahlung transparenten Zwischenfolie **(C)** und von der Reliefschicht **(B)** des Flexodruckelements,
(ii) gegebenenfalls entfernen einer Schutz- oder Deckfolie **(E1)** auf der aufzeichnungsfähigen Vorlageschicht **(D),**
(iii) gegebenenfalls bebildern der aufzeichnungsfähigen Vorlageschicht **(D)** durch belichten und entwickeln,
(iv) transferieren und laminieren der aufzeichnungsfähigen Vorlageschicht **(D)** oder der bebilderten Vorlageschicht **(Da)** auf der für aktinische Strahlung transparenten Zwischenschicht **(C)** oder auf der für aktinische Strahlung transparenten Zwischenfolie **(C)** auf die Reliefschicht **(B)** des Flexodruckelements ***oder*** entfernen der für aktinische Strahlung transparenten Zwischenschicht **(C)** oder der für aktinische Strahlung transparenten Zwischenfolie **(C)** und transferieren der bebilderten Vorlageschicht **(Da)** auf die Reliefschicht **(B)** des Flexodruckelements.

Ein weiterer Aspekt der vorliegenden Erfindung betrifft ein Verfahren zur Herstellung hochauflösender Flexodruckplatten unter Verwendung eines erfindungsgemässen Aufzeichnungselements und Bebilderung mittels digitaler Informationsübertragung unter Verwendung aktinischer Laserstrahlung. Dieses Verfahren umfasst die folgenden Verfahrensschritte:
**(1)** gegebenenfalls **abziehen** der Deckfolie **(El)**,
**(2) belichten** der aufzeichnungsfähigen Vorlageschicht **(D)** mittels aktinischer Laserstrahlung unter Bildung einer belichteten Vorlageschicht,
**(3) entwickeln** der belichteten Vorlageschicht **(D)** unter Bildung einer bebilderten Vorlageschicht **(Da),**
**(4) belichten** des mit der bebilderten Vorlageschicht **(Da)** versehenen Aufzeichnungselements mit aktinischer Strahlung durch die bebilderte Vorlageschicht **(Da)** hindurch.
**(5) entfernen** der Vorlageschicht **(Da),** der gegebenenfalls vorhandenen Zwischenschicht **(C)** sowie der nicht polymerisierten Anteile der reliefbildenden Schicht **(B)** unter Bildung der Flexodruckplatte,
**(6) trocknen** der erhaltenen Flexodruckplatte und
**(7)** gegebenenfalls und vorzugsweise nachbehandeln der Flexodruckplatte mit UV-Licht.

Ein weiterer Aspekt der vorliegenden Erfindung ist ein Verfahren zur Herstellung hochauflösender Flexodruckplatten unter Verwendung eines erfindungsgemässen Halbfabrikats und eines Flexodruckelements und Bebilderung mittels digitaler Informationsübertragung unter Verwendung aktinischer Laserstrahlung. Dieses Verfahren umfasst die folgenden Verfahrensschritte:
**(i)** gegebenenfalls **abziehen** der Deckfolie **(El)** vom Halbfabrikat,
**(ii) belichten** der aufzeichnungsfähigen Vorlageschicht **(D)** auf der für aktinische Strahlung transparenten Zwischenschicht oder der für aktinische Strahlung transparenten Zwischenfolie **(C)** mittels aktinischer Laserstrahlung unter Bildung einer belichteten Vorlageschicht **(D),**
**(iii) entwickeln** der belichteten Vorlageschicht **(D)** unter Bildung einer bebilderten Vorlageschicht **(Da),**
**(iv)** gegebenenfalls **abziehen** einer allenfalls vorhandenen Schutz- oder Deckfolie **(E2)** auf der transparenten Zwischenschicht oder Zwischenfolie **(C)** und einer gegebenenflalls vorhandenen Schutz- oder Deckfolie **(E3)** auf der Reliefschicht **(B),**
**(v) übertragen und laminieren** der bebilderten Vorlageschicht **(Da)** auf der transparenten Zwischenschicht oder Zwischenfolie **(C) *oder*** der bebilderten Vorlageschicht **(Da)** mit oder ohne transparenter Zwischenschicht oder Zwischenfolie **(C)** auf die Reliefschicht **(B)** eines Flexodruckelements umfassend diese Reliefschicht **(B),** eine Trägerfolie **(A)** und gegebenenfalls eine Haftschicht zwischen der Reliefschicht **(B)** und der Trägerfolie **(A),** unter Bildung eines bebilderten Aufzeichnungselements,
**(vi) belichten** des bebilderten Aufzeichnungselements mit aktinischer Strahlung durch die bebilderte Vorlageschicht **(Da)** hindurch.
**(vii) entfernen** der Vorlageschicht **(Da),** gegebenenfalls der Zwischenschicht oder Zwischenfolie **(C)** und der nicht polymerisierten Anteile der Reliefschicht **(B)** unter Bildung der Flexodruckplatte,
**(viii) trocknen** der erhaltenen Flexodruckplatte
**(ix)** gegebenenfalls und vorzugsweise nachbehandeln der Flexodruckplatte mit UV-Licht.

Bei den Verfahren zur Herstellung von Flexodruckplatten wird die mittels aktinischer Strahlung aufzeichnungsfähige Vorlageschicht **(D)** üblicherweise mit aktinischer Laserstrahlung von 10 bis 1500 mJ/cm² im Spektralbereich von 330 nm bis 430 nm, insbesondere von 50 bis 1000 mJ/cm² im angegebenen Spektralbereich, belichtet und nach Belichtung mittels alkalischer Lösung oder alkalischem Dampf, wie Ammoniak, insbesondere unter Verwendung von Ammoniakdampf, entwickelt.

Zur Belichtung der Reliefschicht **(B)** durch die bebilderte Vorlageschicht **(Da)** und gegebenenfalls die für aktinische Strahlung transparente Schicht **(C)** oder Zwischenfolie **(C)** hindurch geeignet ist aktinische UV-Strahlung von >5 bis 100 J/cm² im Spektralbereich von 200 nm bis 450 nm.

Nach Belichtung der Reliefschicht mit einer Strahlungsenergie und für eine Zeit, die zur Vernetzung der belichteten Bereiche führt, können
(i) die bebilderte Vorlageschicht **(Da),** die Zwischenschicht **(C)** und die nicht polymerisierten Teile der Reliefschicht **(B)** mittels eines Auswaschmittels, welches Wasser und/oder Lösungsmittel enthält oder daraus besteht, entfernt werden ***oder***
(ii) die Zwischenfolie **(C)** zusammen mit der bebilderten Vorlageschicht **(Da)** abgezogen und die nicht polymerisierten Teile der Reliefschicht **(B)** mittels eines Auswaschmittels, welches Wasser und/oder Lösungsmittel enthält oder daraus besteht, entfernt werden.

### Beispiele

### Herstellung erfindungsgemässer Aufzeichnungselemente

Die Herstellung der erfindungsgemässen Aufzeichnungselemente kann in 3 Stufen erfolgen:
1.- Herstellung eines Flexodruckelements: Die Komponenten der fotopolymerisierbaren Reliefschicht (B) werden durch einen Extruder auf eine Trägerfolie (A) aufgebracht. Bei der Fertigung eines Flexodruckelements kann eine Schutz/Deckfolie (E3) auf die Aussenseite der Reliefschicht (B) laminiert werden. Ein solches Flexodruckelement mit oder ohne die Schutz/Deckfolie (E3) wurde als Ausgangsmaterial für die folgenden Beispiele eingesetzt. Geeignete Flexodruckelemente sind kommerziell erhältlich. In den folgenden Beispielen verwendet wurde die Flexoplatte *Nyloflex ACE 170* der Fa. Flint.
2.- Eine PET-Folie **(C/E1)** mit oder ohne Haftschicht wurde mit der aufzeichnungsfähigen Vorlageschicht (D) beschichtet. Ist nur eine Folie (C oder El) vorhanden, so kann diese als Folie (C) als Zwischenschicht auf eine fotopolymerisierbare (Relief)schicht (B) laminiert werden oder aber nicht als Zwischenfolie (C) dienen, sondern als Schutz- und Deckfolie bzw. Träger (E1) und von der Vorlageschicht (D) abgezogen werden, derart, dass nur die Vorlageschicht auf die Reliefschicht (B) übertragen wird.
3.-Die aufzeichnungsfähige oder bebilderte Vorlageschicht **(D, Da)** wird auf das Flexodruckelement aufgebracht:
   1. Fall: Die Zwischenfolie (C) und/oder die Schutz- und Deckfolie (El) können hier als Träger wirken. Die Zwischenfolie (C) und die Schutz- und Deckfolie (El) werden zusammen mit der Vorlageschicht (D) auf die Reliefschicht (B) eines Flexodruckelements laminiert.
   2. Fall: Die Schutz- oder Deckfolie (El) wirkt hier als Träger für die Vorlageschicht (D) und eine Zwischenschicht (C). Die Schutz- oder Deckfolie (El) mit der Schicht (D) und der Zwischenschicht (C) wird auf das Flexodruckelement laminiert.
   3. Fall: Die Folie (C) wirkt als Träger für die Vorlageschicht (D). Eine Schutz- oder Deckfolie ist nicht vorgesehen oder wurde vorgängig entfernt. Die Vorlageschicht (D) auf der Folie (C) wird mit Laserstrahlung belichtet, und danach durch alkalische Lösung entwickelt. Anschliessend wird die Folie (C) mit der Schicht (D) auf das Flexodruckelement laminiert, derart dass die bebilderte Vorlageschicht(Da) auf die Reliefschicht des Flexodruckelements übertragen wird. Vor dem UV-Belichtungsvorgang wird die Folie (C) abgezogen.
   4. Fall: Die Folie (C/El) wirkt als Träger für die Vorlageschicht (D). Eine weitere Schutz- oder Deckfolie ist nicht vorgesehen oder wurde vorgängig entfernt. Die Vorlageschicht (D) auf der Folie (C/El) wird mit Laserstrahlung belichtet, und danach durch alkalische Lösung entwickelt. Anschliessend wird die Folie (C) mit der bebilderten Vorlageschicht (Da) auf das Flexodruckelement laminiert, derart, dass die bebilderte Vorlageschicht(Da) direkt auf die Reliefschicht (B) des Flexodruckelements übertragen wird. Die Folie (C/El) wirkt als für die aktinische UV-Strahlung transparente Schutz-/Deckfolie. Nach dem UV-Belichtungsvorgang und vor dem Auswaschvorgang wird die Folie (C/El), gegebenenfalls zusammen mit der bebilderten Vorlageschicht (Da), abgezogen.

### Herstellung der Beschichtungslösung der aufzeichnungsfähigen Vorlageschicht (D):

In einem Glasbehälter wurden 56 g Methylethyketon und 30 g Methanol vorgelegt. Dann wurden 9 g Celluloseacetatpropionat (CAP)-Bindemittel(erhältlich v. Fa. Sigma-Aldrich) bei Raumtemperatur eingerührt. Nach 40 Minuten wurden 0.9 g Benzolsulfonsäure (erhältlich v. Fa. Sigma-Aldrich)eingerührt. Nach 20 Minuten wurden 2.0 g Diazoniumverbindung (Ia) [A: Cl, B: N(Et)₂, oder N(Me)₂; C: H, X⁻: BF₄⁻ oder PF₆⁻] (erhältlich v. Fa.Chemos GmbH) eingemischt. 20 Minuten später wurden 2 Kupplerverbindungen (II) nacheinander zugegeben: 0.28 g 3,5-Dihydroxybenzoesäure (Kupplerverbindung (IId) mit F = H und G = (HO)C=O)) und 1.70 g 2,2'-Biphenol (Kupplerverbindung (III) mit R1 bis R4 = H, R1' bis R4' = H und Z = Bindung) (erhältlich v. Fa. Aldrich Chemical)) und 0.20 g eines silikonhaltigen Oberflächenadditivs (BYK-300; erhältlich v. Fa. BYK)

### Herstellung der Beschichtungslösung der Zwischenschicht (C) :

### Polyvinylbutyral (Mowital) als Bindemittel

In einem Glasbehälter wurden 70 g IsoPropanol mit 20g Wasser gemischt. Danach wurden 10 g Mowital B16H (erhältlich von der Firma Kuraray) zugesetzt und 60 Minuten gerührt. Die fertige Lösung war einsatzbereit.

### Polyvinylalkohol als Bindemittel

In einem Glasbehälter wurden 95 g Wasser mit 0.05 g Capstone FS-30 (ethoxyliertes, nichtionisches Fluortensid) gemischt. Danach wurden 5 g Polyvinylalkohol Poval 40-88 teilverseift (erhältlich von der Firma Kuraray) zugesetzt und 60 Minuten gerührt. Die fertige Lösung war einsatzbereit.

Als Flexodruckelement für die verschiedenen Beispiele wurde die Platte "nyloflex® ACE 170" der Fa. Flint ohne die aufzeichnungsfähige Schicht verwendet. Sie besteht aus einer Trägerfolie (A) mit ca. 125 µm Dicke und aus einer fotopolymerisierbaren Reliefschicht (B) mit ca. 1650 - 1700 µm Dicke und einer Schutzfolie (E3) mit ca. 125 µm Dicke.

### Vergleichsbeispiel I:

Als aufzeichnungsfähige Schicht wurde ein Diazofilm DPC-HRP der Fa. Folex AG verwendet. Die bebilderte Vorlageschicht wurde gemäss den Verfahrensschritten a) und b) von Bsp.l erhalten und anschliessend auf das Flexodruckelement nyloflex® ACE 170 (ohne russhaltige Schicht (LAMS)) gemäss dem Verfahrensschritt c) von Bsp.l kopiert.

### Vergleichsbeispiel II:

Die aufzeichnungsfähige Schicht (D) war eine russhaltige Schicht (LAMS), die Teil der nyloflex® ACE 170 digital von Flint ist. Die russhaltige Schicht wurde mit Multi DX 220 der Fa. Lüscher belichtet. Danach wurde das bebilderte Aufzeichnungselement gemäss Verfahrensschritt c) von Bsp.l belichtet und weiter verarbeitet.

### Vergleichsbeispiel III:

Die aufzeichnungsfähige Schicht war eine russhaltige Schicht (LAMS), die Teil der CYREL® DSP Platte von Dupont ist. Die russhaltige Schicht wurde mit Multi DX 220 der Fa. Lüscher belichtet. Danach wurde das bebilderte Aufzeichnungselement gemäss Verfahrensschritt c) von Bsp.l belichtet und weiter verarbeitet.

### Vergleichsbeispiel IV:

Die aufzeichnungsfähige Schicht war eine russhaltige Schicht (LAMS), die Teil der Digital LUX-ITP Platte von Mac Dermid ist. Die russhaltige Schicht wurde mit Multi DX 220 der Fa. Lüscher belichtet. Danach wurde das bebilderte Aufzeichnungselement gemäss Verfahrensschritt c) von Bsp.l belichtet und weiter verarbeitet.

### Beispiel 1:

Die aufzeichnungsfähige Vorlageschicht (D) wurde auf eine dünne Zwischenfolie (C) als Trennschicht aufgebracht und anschliessend auf die Reliefschicht (B) des Flexodruckelements laminiert. **(1. Fall)**

Die Formulierung der aufzeichnungsfähigen Vorlageschicht (D) wurde auf eine 6 µm-PET-Folie (C) mit einer Auftragsmenge von ca. 15g/m² Feststoff aufgetragen und dann in einem Ofen bei einer Temperatur von 130°C während 2 Min. getrocknet. Die Zwischenfolie (C) mit der Schicht (D) wurde mindesten 24 Stunden bei Raumtemperatur, ca. 20°C, und 50% rel. Feuchtigkeit gelagert. Aufgrund der Herstellung und Weiterverarbeitung innerhalb der gleichen Laborräumlichkeiten wurde auf Abdeckung der aufzeichnungsfähigen Vorlageschicht (D) mit einer Abdeckfolie (E1) verzichtet. Anschliessend an die Lagerung wurde die Zwischenfolie (C) mit der Schicht (D) - nach Entfernen der Schutzfolie (E3) - auf die Reliefschicht (B) des Flexodruckelements laminiert. Es wurde ein erfindungsgemässes Aufzeichnungselement erhalten, das zur Herstellung der fertigen Flexodruckplatte bereit steht.
a) Das erhaltene Aufzeichnungselement wurde mit einem Laserbelichter des Typs Multi DX 220 der Fa. Lüscher mit einer Energie von 500 mJ/cm² bei einer Wellenlänge von 405 nm und mit 2540 dpi belichtet und
b) anschliessend in Ammoniakdampf (erzeugt aus einer alkalischen Lösung (25% Ammoniak) bei einer Temperatur von mindestens 70°C, maximal 95°C) entwickelt.
c)Danach wurde die Druckplatte mit der in Schritt b) erhaltenen Maske, bzw. der bebilderten Vorlageschicht (Da), mit einem UV-Belichter des Typs Cyrel 2001 E während 50 Sek. (Sockel)/ 600 Sek.(Vorderseite) mittels UV-A-Strahlung belichtet.
d)Anschliessend wurden - nach Abziehen der Folie (C) zusammen mit der Schicht (Da) - die nicht polymerisierten Bereiche der Reliefschicht (B) mit nylosolv® A der Fa Flint in einem Dupont-Prozessor des Typs CYREL 3000P während 15 Min. ausgewaschen.

e)Die erhaltene Flexodruckplatte wurde während 120 Minuten bei einer Temperatur von ca. 65°C getrocknet.
f)Danach wurde die Flexodruckplatte nachbelichtet:
   Zuerst ca. 11 Minuten mit UV-C Strahlung, um die Klebrigkeit an der Oberfläche zu minimieren,
   dann ca. 10 Minuten mit UV-A Strahlung, um eine ausreichende Nachhärtung zu erreichen.

Die derart gefertigte Flexodruckplatte war bereit für den Einsatz.

### Beispiel 2:

Die aufzeichnungsfähige Vorlageschicht (D) auf einer dünnen Folie (C/El) wurde separat belichtet, anschliessend in alkalischer Lösung entwickelt und die entwickelte Schicht (Da) von der Folie (C/El) auf die Reliefschicht (B) des Flexodruckelements übertragen (**3. Fall**).

Die Formulierung der Schicht (D) wurde auf eine 100 µm-PET-Folie (C/El) ohne Haftschicht mit einer Auftragsmenge von ca. 15g/m² aufgetragen, dann im Ofen bei einer Temperatur von 130°C während 2 Min. getrocknet und anschliessend mindesten 24 Stunde bei Raumtemperatur, ca. 20°C, und 50% rel. Feuchtigkeit gelagert. Dieses Halbfabrikat wurde dann mit einem Laserbelichter des Typs Multi DX 220 der Fa. Lüscher mit einer Energie von 500 mJ/cm² bei einer Wellenlänge von 405 nm und mit 2540 dpi belichtet und anschliessend in Ammoniakdampf (erzeugt aus einer alkalischen Lösung (25% Ammoniak) bei einer Temperatur von mindestens 70°C, maximal 95°C) entwickelt.

Die bebilderte Vorlageschicht (Da) wurde vom Träger(C/E1) auf die Reliefschicht (B) des Flexodruckelements unter Bildung eines bebilderten Aufzeichnungselements übertragen.

Das erhaltene Aufzeichnungselementelement wurde durch die Maske bzw. die bebilderte Vorlageschicht (Da) mit einem UV-Belichter des Typs Cyrel 2001 E während 50 Sek. (Sockel)/ 600 Sek.(Vorderseite) belichtet und anschliessend mit nylosolv® A der Fa Flint in einem Dupont-Prozessor des Typs CYREL 3000P während 15 Min. ausgewaschen.

Die erhaltene Flexodruckplatte wurde dann analog Beispiel 1, Schritte e) und f), weiterbehandelt.

### Beispiel 3:

Die aufzeichnungsfähige Vorlageschicht (D) auf einer UV-durchlässigen dünnen Träger- bzw. Schutzfolie (C/El) wurde separat belichtet und anschliessend in Ammoniakdampf (erzeugt aus einer alkalischen Lösung (25% Ammoniak) bei einer Temperatur von mindestens 70°C, maximal 95°C) entwickelt. Die derart hergestellte bebilderte Vorlageschicht (Da) wurde zusammen mit der Träger-/Schutzfolie (C/E1) auf die Reliefschicht (B) des Flexodruckelements laminiert. (**4. Fall**).

Die Formulierung der Schicht (D) wurde auf eine 100 µm-PET-Folie (C/El) ohne Haftschicht mit einer Auftragsmenge von ca. 15g/m² aufgetragen und dann im Ofen bei einer Temperatur von 130°C während 2 Min. getrocknet und anschliessend mindesten 24 Stunde bei Raumtemperatur, ca. 20°C, und 50% rel. Feuchtigkeit gelagert. Dieses Halbfabrikat wurde dann mit einem Laserbelichter des Typs Multi DX 220 der Fa. Lüscher mit einer Energie von 500 mJ/cm² bei einer Wellenlänge von 405 nm und mit 2540 dpi belichtet und anschliessend in Ammoniakdampf (erzeugt aus einer alkalischen Lösung (25% Ammoniak) bei einer Temperatur von mindestens 70°C, maximal 95°C) entwickelt.

Die Schicht (Da) wurde zusammen mit der Träger-/Schutzfolie (C/El) unter Bildung eines bebilderten Aufzeichnungselements auf die Reliefschicht (B) des Flexodruckelements laminiert.

Das erhaltene Aufzeichnungselementelement wurde durch die Maske bzw. die bebilderte Vorlageschicht (Da) mit einem UV-Belichter des Typs Cyrel 2001 E während 50 Sek. (Sockel)/ 600 Sek.(Vorderseite) belichtet. Nach mechanischem Abziehen der Träger-/Schutzfolie (C/El) zusammen mit der Maske (bebilderte Vorlageschicht (Da)) wurden die nicht polymerisierten Bereiche der Reliefschicht (B) mit nylosolv® A der Fa Flint in einem Dupont-Prozessor des Typs CYREL 3000P während 15 Min. ausgewaschen.

Die erhaltene Flexodruckplatte wurde dann analog Beispiel 1, Schritte e) und f), weiterbehandelt.

### Beispiel 4:

Die aufzeichnungsfähige Vorlageschicht wurde gemäss Erfindung mit einer Zwischenschicht als Trennschicht aufgebracht. (**2. Fall**)

Die Formulierung der aufzeichnungsfähigen Vorlageschicht (D) wurde auf eine 100 µm-PET-Folie (El) ohne Haftschicht mit einer Auftragsmenge von ca. 15g/m² aufgetragen und dann im Ofen bei einer Temperatur von 130°C während 2 Min. getrocknet. Anschliessend wurde die Zwischenschicht (C), als deren Bindemittel Mowital verwendet wurde, auf die Schicht (D) mit einer Auftragsmenge von ca. 3 g/m² aufgetragen und im Ofen bei einer Temperatur von 70°C während 2 Min. getrocknet. Das derart hergestellte zweischichtige Material aus der aufzeichnungsfähigen Vorlageschicht (D) und der für aktinische Laserstrahlung transparenten Zwischenschicht (C) wurde unter gleichzeitiger Entfernung der Trägerfolie (E1) und unter Bildung des Aufzeichnungselements auf die Reliefschicht (B) des Flexodruckelements übertragen.

Das derart hergestellte Aufzeichnungsmaterial wurde, wie in Beispiel 1 beschrieben, mittels Laser belichtet, in alkalischer Lösung entwickelt und die fotopolymerisierbare Reliefschicht durch die Maske, bzw. die bebilderte Vorlageschicht (Da), belichtet. Anschliessend wurden die Schichten (Da) und (C) und die nicht polymerisierten Bereiche der Reliefschicht (B) mit nylosolv® A der Fa Flint in einem Dupont-Prozessor des Typs CYREL 3000P während 15 Min. ausgewaschen.

Die erhaltene Flexodruckplatte wurde dann analog Beispiel 1, Schritte e) und f), weiterbehandelt.

### Beispiel 5:

Die aufzeichnungsfähige Vorlageschicht wurde gemäss Erfindung mit einer Zwischenschicht als Trennschicht aufgebracht (**2. Fall**).

Es wurde analog Beispiel 5 vorgegangen, mit dem Unterschied dass als Bindemittel der Zwischenschicht (C) anstelle von Mowital Polyvinylalkohol verwendet wurde.

### Vergleich der Vergleichsbeispiele I, II, III und IV mit den erfindungsgemässen Beispielen 1, 2, 3, 4 und 5

### Auswertung

Die erhaltenen Flexodruckplatten wurden anhand des bebilderten UGRA/FOGRA-Digital-Plattenkeils, der unterschiedlichen bebilderten Schriftgrössen (0.5 pt. bis 8 pt.) sowie der bebilderten Punktgrössen und Linienschärfen (von 20 bis 600 µm) unter dem Mikroskop bei einer 30-fachen Vergrösserung geprüft. Folgende Merkmale wurden gewertet:
**1.** ***Bestimmung der Punktgrösse in µm:*** die bebilderten Punkte wurden im Mikroskop gemessen und ausgewertet und die kleinste Punktgrösse, die sichtbar und druckfähig war, wurde als Referenzwert aufgenommen.
**2. *Bestimmung der Schriftgrösse in pt:*** Die bebilderten Buchstaben auf einer Skala von 0.5 bis 6.0 pt wurden im Mikroskop ausgewertet und die kleinste Schriftgrösse, die als lesbar und scharf beurteilt wurde, wurde als Referenzwert aufgenommen.
**3. *Bestimmung der Linienbreite in µm*:** Die bebilderten Linien wurden im Mikroskop gemessen und ausgewertet. Die schmalste sichtbare und für die Druckwiedergabe ausreichend scharfe Linie wurde als Referenzwert aufgenommen.
**4. Bestimmung *des niedrigsten* und *höchsten Tonwerts (%) :*** Auf dem Verlaufs-/Stufenkeil (UGRA/FOGRA-Digital-Plattenkeil) wurden die abgestuften Tonwerte von 0 bis 100% mittels Mikroskop gemessen und ausgewertet. Der kleinste und der höchste Tonwert des Verlaufs-/Stufenkeils mit ausreichendem Profil für die Druckwiedergabe wurden als Referenzwerte aufgenommen.

**Ergebnisse:**

| **Beispiel** | **Punktgrösse sichtbar ab : [µm] 1** | **Schriftgrösse lesbar ab : [pt] 2** | **Linienbreite sichtbar ab : [µm] 3** | **Verlaufskeil niedrigster / höchster Tonwert [%] 4** |
|---|---|---|---|---|
| **Vgl. I** | 100 | 1 | 40 | 3.0 / 95.0 |
| **Vgl. II** | 100 | 1 (zerfranst) | 50 | 3.0 / 97.0 |
| **Vgl. III** | 500 | 2 (zerfranst) | 100 | 4.0 / 94.0 |
| **Vgl. IV** | 75 | 1 | 50 | 1.0 / 97.0 |
| **1** | 40 | 0.5 | 20 | 1.0 / 97.0 |
| **2** | 40 | 0.5 | 20 | 1.0 / 97.0 |
| **3** | 40 | 0.5 | 20 | 1.0 / 97.0 |
| **4** | 40 | 0.5 | 20 | 1.0 / 97.0 |
| **5** | 40 | 0.5 | 20 | 1.0 / 97.0 |

Die Versuche belegen, dass die erfindungsgemässen Aufzeichnungselemente eine hohe Auflösung besitzen, sehr feine Oberflächenstrukturen abbilden können und den Stand der Technik übertreffen.

Während in der vorliegenden Anmeldung bevorzugte Ausführungen der Erfindung beschrieben sind, ist klar darauf hinzuweisen, dass die Erfindung nicht auf diese beschränkt ist und in auch anderer Weise innerhalb des Umfangs der folgenden Ansprüche ausgeführt werden kann.

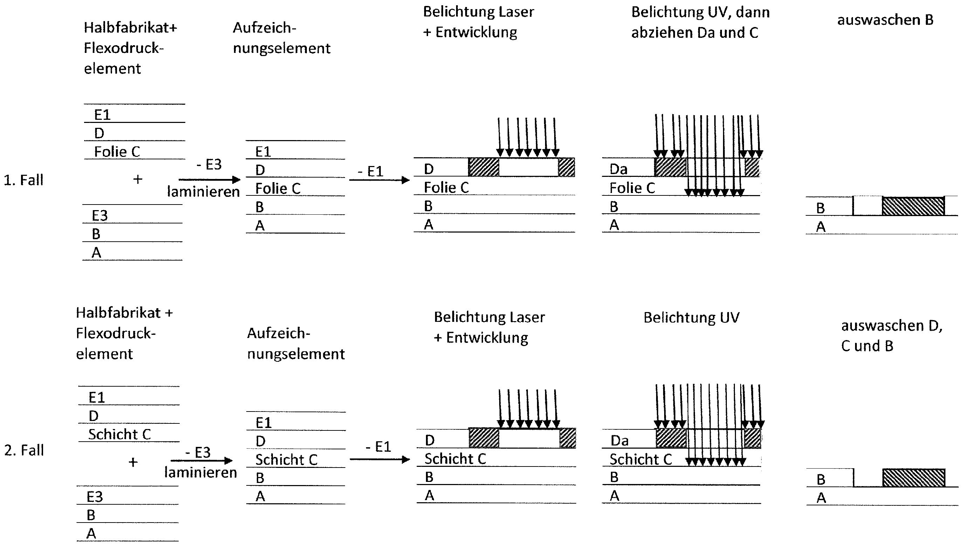

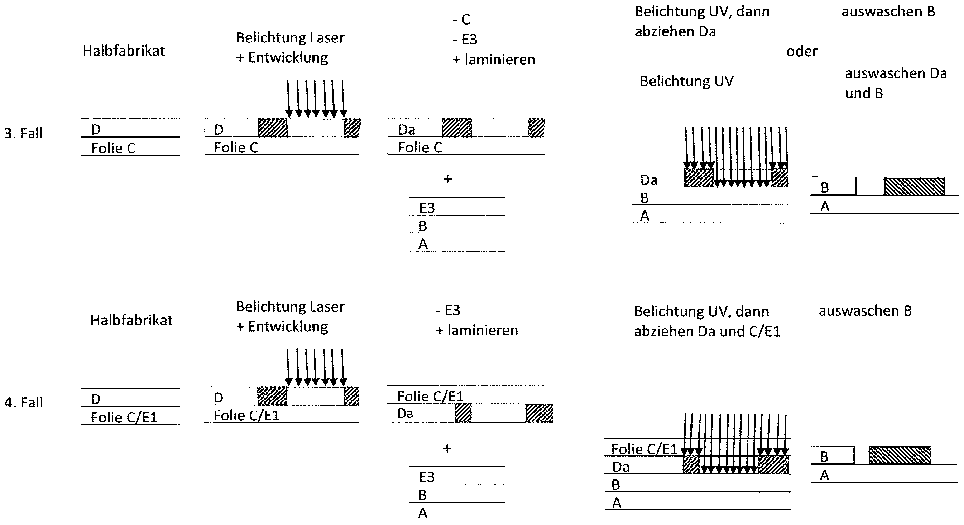

## Patentansprüche

1. Aufzeichnungselement, das zur Herstellung von hochauflösenden Flexodruckplatten durch digitale Informationsübertragung geeignet und mit aktinischer Laserstrahlung bebilderbar oder bebildert ist und welches in der genannten Reihenfolge übereinander angeordnet die folgenden Schichten enthält oder daraus besteht:
**(A)** eine Trägerfolie, die optional auf der mit einer fotopolymeriserbaren Schicht/Reliefschicht versehenen Seite mit einer Haftschicht versehen sein kann,
**(B)** eine in organischen und/oder wässerigen Lösemitteln lösliche fotopolymerisierbare Schicht/Reliefschicht, die durch aktinische Strahlung vernetzbar ist,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt oder
**(Da)** eine bebilderte Vorlageschicht, in der die monomere Diazonium-Verbindung in mindestens einem Bereich durch aktinische Laserstrahlung zerstört ist und in mindestens einem nicht belichteten Bereich infolge Entwickelns eine erhöhte aktinische Dichte hat.

2. Das Aufzeichnungselement gemäss Anspruch 1, **dadurch gekennzeichnet, dass** zwischen den Schichten **(B)** und **(D)** eine Schicht **(C)** angeordnet ist, wobei die Schicht
**(C)** eine für aktinische Strahlung transparente Zwischenschicht oder eine für aktinische Strahlung transparente Zwischenfolie als Trennelement ist.

3. Das Aufzeichnungselement gemäss Anspruch 1 oder 2, **dadurch gekennzeichnet, dass** es
die aufzeichnungsfähige Vorlageschicht **(D)** und auf dieser Schicht zusätzlich
eine abziehbare Schutz- oder Deckfolie **(El)** umfasst.

4. Das Aufzeichnungselement gemäss einem der vorangehenden Ansprüche, **dadurch gekennzeichnet, dass** die aufzeichnungsfähige oder bebilderte Vorlageschicht **(D, Da)** eine Schichtdicke von 1 µm bis 50 µm, vorzugsweise von 3 µm bis 30 µm, aufweist.

5. Das Aufzeichnungselement gemäss einem der vorangehenden Ansprüche, **dadurch gekennzeichnet, dass** die aufzeichnungsfähige Vorlageschicht **(D)** mit aktinischer Laserstrahlung einer Leistung von 10 bis 1500 mJ/cm² im Spektralbereich von 330 nm bis 430 nm, insbesondere von 50 bis 1000 mJ/cm² im angegebenen Spektralbereich, belichtbar ist.

6. Das Aufzeichnungselement gemäss einem der vorangehenden Ansprüche, **dadurch gekennzeichnet, dass** die aufzeichnungsfähige Vorlageschicht mittels einer alkalischen Lösung oder alkalischer Dämpfe, wie Ammoniakdampf, entwickelt werden kann, derart, dass die unbelichteten Bereiche für aktinische Strahlung weniger durchlässig werden, insbesondere derart, dass die nicht belichteten, entwickelten Bereiche der aufzeichnungsfähige Vorlageschicht eine aktinische Dichte > 3.0 aufweisen.

7. Das Aufzeichnungselement gemäss einem der vorangehenden Ansprüche, **dadurch gekennzeichnet, dass** die aufzeichnungsfähige Vorlageschicht zu mindestens 70 Gew.-%, insbesondere zu mind. 85 Gew.-% aus einem Gemisch aus mindesten einem auf Celluloseester basierten Bindemittel und einer Diazoniumverbindung und einer reaktiven Kuppler-Verbindung besteht, wobei
die Diazoniumverbindung ein Diazoniumsalz gemäss Formel **(I)** ist,
**R-N≡N⁺X⁻** **(I)**
worin **R** eine substituierte oder unsubstituierte organische Gruppe wie eine Alkyl-, Acyl-, oder aromatische Gruppe bedeutet und
**X⁻** ein Anion ist, insbesondere ausgewählt aus der Gruppe umfassend BF₄⁻, AsF₆⁻, ClO₄⁻, SbF₆⁻, CF₃SO₃⁻, SO₄⁻, PF₆⁻ PO₄³⁻, NO₃⁻, Br⁻, Cl⁻, I⁻, F⁻, Arylsulfonat, wie p-Chlorbenzolsulfonat, Alkylsulfonat, Allylsulfonat, oder ein Metallkomplexanion, z.B. ZnCl₃⁻, SnCl₆²⁻
und die reaktive Kuppler-Verbindung, insbesondere eine Kupplerverbindung der Formel **(II)** ist, 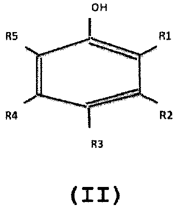
worin **R1, R2, R3, R4 und R5** gleich oder verschieden sein können und ausgewählt sind aus der Gruppe umfassend -OH, -SO₃H, -CONH-R6 (R6=Alkyl-, Aryl-, Cycloalkyl, Alkoxy), Alkoxygruppe, Carboxygruppe, Guanidingruppe, Aminogruppe, Acylamidogruppe, Thioharnstoffgruppe, Thiogruppe, Wasserstoff oder Halogen, oder
**R1 und R2** oder **R2 und R3** zusammen einen Butadienylrest bilden,
und worin das Verhältnis von Bindemittel zu Diazoverbindung üblicherweise von 50 : 1 bis 1 : 2, vorzugsweise 20 : 1 bis 1 : 1 beträgt und das Verhältnis von Diazoverbindung zu Kupplerverbindung von 4 : 1 bis 1 : 4, vorzugsweise 2 : 1 bis 1 : 2 ist.

8. Das Aufzeichnungselement gemäss einem der vorangehenden Ansprüche, **dadurch gekennzeichnet, dass**
die für aktinische Strahlung transparente Zwischenschicht **(C)** oder die für aktinische Strahlung transparente Zwischenfolie **(C)** eine Dicke von bis zu 200 pm, wie 0.5 µm bis 200 µm, vorzugsweise von 1 µm bis 100 pm, insbesondere von 2 µm bis 50 µm, speziell bevorzugt von 3 µm bis 15 µm aufweist.

9. Das Aufzeichnungselement gemäss einem der vorangehenden Ansprüche, **dadurch gekennzeichnet, dass** es eine für aktinische Strahlung transparente Zwischenschicht **(C)** umfasst, die zu mind. 70 Gew.-%, insbesondere zu mind. 85 Gew.-% aus mindesten einem Bindemittel besteht, welches auf mindestens einem in Wasser und/oder organischem Lösungsmittel löslichen Polymer oder Copolymer basiert und sich durch Wasser und/oder Lösungsmittel entfernen lässt, wie Polyvinylalkohole, teil- oder hochverseifte Polyvinylcarboxylate, Polyvinylacetate, Poly(ethylenoxid-vinylalcohol)- oder Poly(ethylenoxidvinylalcohol)-Copolymere, Polyvinylbutyral, Polyurethan, Polyvinylpyrrolidon, Gelatine oder Mischung derselben, insbesondere Polymere aus der Gruppe bestehend aus Polyvinylalkohol, Polyvinypyrrolidon, Polyamid, Polyurethan und Gelatine oder Mischung derselben.

10. Das Aufzeichnungselement gemäss einem der vorangehenden Ansprüche, **dadurch gekennzeichnet, dass** es eine für aktinische Strahlung transparente Zwischenfolie **(C)** umfasst, welche sich von der Reliefschicht **(B)** mechanisch entfernen, insbesondere abziehen, lässt, insbesondere eine Zwischenfolie **(C),** die ausgewählt ist aus der Gruppe bestehend aus Polymerfilmen, wie Polyester, z.B. Polyethylenterephthalat (PET), Polybutylenterephthalat (PBT), Polyethylennaphthalat (PEN) und Polymethylmethacrylat (PMMA), Polyamid oder Polycarbonat, oder Polyolefine, wie Polyethylen (PE), Polypropylen (PP), Polymethylpenten (PMP) und Polybutylen (PB, PIB) oder Fluorpolymere, wie Tetrafluorethylen (PTFE), Polyvinylidenfluorid (PVDF), Ethylen-Tetrafluorethylen (ETFE), Polyvinylfluorid (PVF) und Perfluorethylenpropylen_(PEP, FEP) oder Polyarylsufone, wie Polysulfon (PSU) und Polyethersulfon (PES), insbesondere PET-Folien.

11. Das Aufzeichnungselement gemäss einem der vorangehenden Ansprüche, **dadurch gekennzeichnet, dass** die Reliefschicht **(B)** eine Schichtdicke von 200 µm bis 8000 pm, insbesondere 300 µm bis 6000 µm, aufweist und/oder mindestens ein elastomeres Bindemittel, mindestens zwei ethylenisch ungesättigte copolymerisierbare organische Verbindung (Monomere) und einen Fotoinitiator oder ein Fotoinitiatorsystem enthält oder daraus besteht.

12. Halbfabrikat zur Herstellung eines Aufzeichnungselements gemäss einem der Ansprüche 1 bis 11, **dadurch gekennzeichnet, dass** es die folgenden Schichten enthält oder daraus besteht:
**(C)** eine für aktinische Strahlung transparente Zwischenschicht oder eine für aktinische Strahlung transparente Zwischenfolie,
**(D)** eine aufzeichnungsfähige Vorlageschicht umfassend eine monomere Diazonium-Verbindung, die gegen aktinische Laserstrahlung lichtempfindlich ist und durch Entwickeln eine Änderung in der aktinischen Dichte erfährt ***oder***
**(Da)** eine bebilderte Vorlageschicht, in der die monomere Diazonium-Verbindung in mindestens einem Bereich durch aktinische Laserstrahlung zerstört ist und in mindestens einem nicht belichteten Bereich durch Entwickeln eine erhöhte aktinische Dichte aufweist.

13. Das Halbfabrikat gemäss Anspruch 12, **dadurch gekennzeichnet, dass** es
auf der aufzeichnungsfähigen Vorlageschicht **(D)** eine abziehbare Schutz- oder Deckfolie **(El)**
und/oder auf der für aktinische Strahlung transparenten Zwischenschicht **(C)** oder auf der für aktinische Strahlung transparenten Zwischenfolie **(C),** insbesondere auf der für aktinische Strahlung transparenten Zwischenschicht **(C),** eine abziehbare Schutz- oder Deckfolie **(E2)** aufweist.

14. Verfahren zur Herstellung eines Aufzeichnungselements gemäss einem der Ansprüche 1 bis 11, unter Verwendung eines Halbfabrikats gemäss Anspruch 12 oder 13 und eines Flexodruckelements umfassend eine Trägerfolie **(A),** eine Reliefschicht **(B),** gegebenenfalls eine Haftschicht zwischen der Reliefschicht **(B)** und der Trägerfolie **(A)** und gegebenenfalls eine abziehbare Schutz- oder Deckfolie **(E3)** auf der Reliefschicht **(B), dadurch gekennzeichnet, dass** es die folgenden Schritte umfasst:
(i) entfernen gegebenenfalls vorhandener Schutz- oder Deckfolien **(E2), (E3)** von der für aktinische Strahlung transparenten Zwischenschicht **(C)** oder der für aktinische Strahlung transparenten Zwischenfolie **(C)** und von der Reliefschicht **(B)** des Flexodruckelements,
(ii) gegebenenfalls entfernen einer Schutz- oder Deckfolie **(El)** auf der aufzeichnungsfähigen Vorlageschicht **(D),**
(iii) gegebenenfalls bebildern der aufzeichnungsfähigen Vorlageschicht **(D)** durch belichten und entwickeln,
(iv) transferieren und laminieren der aufzeichnungsfähigen Vorlageschicht **(D)** oder der bebilderten Vorlageschicht **(Da)** auf der für aktinische Strahlung transparenten Zwischenschicht **(C)** oder auf der für aktinische Strahlung transparenten Zwischenfolie **(C)** auf die Reliefschicht **(B)** des Flexodruckelements ***oder*** entfernen der für aktinische Strahlung transparenten Zwischenschicht **(C)** oder der für aktinische Strahlung transparenten Zwischenfolie **(C)** und transferieren der bebilderten Vorlageschicht **(Da)** auf die Reliefschicht **(B)** des Flexodruckelements.

15. Verfahren zur Herstellung hochauflösender Flexodruckplatten unter Verwendung eines Aufzeichnungselements gemäss einem der Ansprüche 1 bis 11 und Bebilderung mittels digitaler Informationsübertragung unter Verwendung aktinischer Laserstrahlung, **dadurch gekennzeichnet, dass** es die folgenden Verfahrensschritte umfasst:
**(1)** gegebenenfalls **abziehen** der Deckfolie **(El),**
**(2) belichten** der aufzeichnungsfähigen Vorlageschicht **(D)** mittels aktinischer Laserstrahlung unter Bildung einer belichteten Vorlageschicht,
**(3) entwickeln** der belichteten Vorlageschicht unter Bildung einer bebilderten Vorlageschicht **(Da),**
**(4) belichten** des mit der bebilderten Vorlageschicht **(Da)** versehenen Aufzeichnungselements mit aktinischer Strahlung durch die bebilderte Vorlageschicht **(Da)** hindurch,
**(5) entfernen** der Vorlageschicht **(Da),** der gegebenenfalls vorhandenen Zwischenschicht **(C)** sowie der nicht polymerisierten Anteile der reliefbildenden Schicht **(B)** unter Bildung der Flexodruckplatte,
**(6) trocknen** der erhaltenen Flexodruckplatte und
**(7)** gegebenenfalls und vorzugsweise **nachbehandeln** der Flexodruckplatte mit UV-Licht.

16. Verfahren zur Herstellung hochauflösender Flexodruckplatten unter Verwendung eines Halbfabrikats gemäss Anspruch 12 oder 13 und Bebilderung mittels digitaler Informationsübertragung unter Verwendung aktinischer Laserstrahlung, **dadurch gekennzeichnet, dass** es die folgenden Verfahrensschritte umfasst:
**(i)** gegebenenfalls **abziehen** der Deckfolie **(E1)** vom Halbfabrikat,
**(ii) belichten** der aufzeichnungsfähigen Vorlageschicht **(D)** auf der für aktinische Strahlung transparenten Zwischenschicht **(C)** oder der für aktinische Strahlung transparenten Zwischenfolie **(C)** mittels aktinischer Laserstrahlung unter Bildung einer belichteten Vorlageschicht,
**(iii) entwickeln** der belichteten Vorlageschicht unter Bildung einer bebilderten Vorlageschicht **(Da)**,
**(iv)** gegebenenfalls **abziehen** einer allenfalls vorhandenen Schutz- oder Deckfolie **(E2)** auf der transparenten Zwischenschicht oder Zwischenfolie **(C)**
**(v) übertragen und laminieren** der bebilderten Vorlageschicht **(Da)** auf der transparenten Zwischenschicht oder Zwischenfolie **(C) *oder*** der bebilderten Vorlageschicht **(Da)** auf die Reliefschicht **(B)** eines Flexodruckelements umfassend diese Reliefschicht **(B),** eine Trägerfolie **(A)** und gegebenenfalls eine Haftschicht zwischen der Reliefschicht **(B)** und der Trägerfolie **(A),** unter Bildung eines bebilderten Aufzeichnungselements,
**(vi) belichten** des bebilderten Aufzeichnungselements mit aktinischer Strahlung durch die bebilderte Vorlageschicht **(Da)** hindurch.
**(vii) entfernen** der Vorlageschicht **(Da),** gegebenenfalls der Zwischenschicht oder Zwischenfolie **(C)** und der nicht polymerisierten Anteile der Reliefschicht **(B)** unter Bildung der Flexodruckplatte,
**(viii) trocknen** der erhaltenen Flexodruckplatte
**(ix)** gegebenenfalls und vorzugsweise nachbehandeln der Flexodruckplatte mit UV-Licht.

17. Verfahren gemäss einem der Ansprüche 14 bis 16, **dadurch gekennzeichnet, dass** die mittels aktinischer Strahlung aufzeichnungsfähige Schicht **(D)** mit aktinischer Laserstrahlung von 10 bis 1500 mJ/cm² im Spektralbereich von 330 nm bis 430 nm, insbesondere von 50 bis 1000 mJ/cm² im angegebenen Spektralbereich, belichtet wird.

18. Verfahren gemäss einem der Ansprüche 14 bis 17, **dadurch gekennzeichnet, dass** die aufzeichnungsfähige Vorlageschicht nach Belichtung unter Verwendung einer alkalischen Lösung oder eines alkalischen Dampfes, insbesondere Ammoniakdampf, entwickelt wird.

19. Verfahren gemäss einem der Ansprüche 15 bis 18, **dadurch gekennzeichnet, dass** die Reliefschicht **(B)** durch die bebilderte Vorlageschicht **(Da)** und gegebenenfalls die für aktinische Strahlung transparente Zwischenschicht oder Zwischenfolie **(C)** hindurch mit aktinischer Strahlung von >5 bis 100 J/cm² im Spektralbereich von 200 nm bis 450 nm belichtet wird.

20. Verfahren gemäss einem der Ansprüche 15 bis 19, **dadurch gekennzeichnet, dass**
(i) die Vorlageschicht **(Da),** die Zwischenschicht **(C)** und die nicht polymerisierten Teile der Reliefschicht **(B)** mittels eines Auswaschmittels, welches Wasser und/oder Lösungsmittel enthält oder daraus besteht, entfernt werden ***oder*** dass
(ii) die Zwischenfolie **(C)** zusammen mit der Vorlageschicht **(Da)** abgezogen und die nicht polymerisierten Teile der Reliefschicht **(B)** mittels eines Auswaschmittels, welches Wasser und/oder Lösungsmittel enthält oder daraus besteht, entfernt werden.

21. Verwendung einer aufzeichnungsfähigen Vorlageschicht umfassend eine monomere Diazonium-Verbindung, die gegen aktinische Laserstrahlung lichtempfindlich ist und durch Entwickeln eine Änderung in der aktinischen Dichte erfährt, zur Herstellung von Flexodruckplatten, insbesondere mittels eines Halbfabrikats gemäss einem der Ansprüche 12 oder 13 oder zur Herstellung eines Aufzeichnungselements gemäss einem der Ansprüche 1 bis 11, oder in einem Halbfabrikat gemäss einem der Ansprüche 12 oder 13 oder in einem Aufzeichnungselement gemäss einem der Ansprüche 1 bis 11.

## Claims

1. A recording element which is suitable for the production of high-resolution flexographic printing plates by means of digital information transmission, that can be imagined with actinic laser radiation or that is imaged, said recording element comprises or consists of the following layers arranged one above the other in the stated sequence:
**(A)** a carrier film, optionally provided with an adhesive layer on the side provided with a photopolymerizable layer/relief layer,
**(B)** a photopolymerizable layer/relief layer which is soluble in organic solvents and/or aqueous solvents and which is crosslinkable by actinic radiation,
**(D)** a recordable template layer comprising a monomeric diazonium compound which is photosensitive to actinic laser radiation and undergoes a change in actinic density by development or
**(Da)** an imaged template layer in which the monomeric diazonium compound is destroyed by actinic laser radiation in at least an area and has an increased actinic density in at least one unexposed area due to development.

2. The recording element according to claim 1, **characterized in that** there is a layer **(C)** arranged between layers **(B)** and layer **(D)** wherein said layer (C) is an actinic radiation transparent intermediate layer or an actinic radiation transparent intermediate film as a separating element.

3. The recording element according to claim 1 or 2, **characterized in that** it comprises
the recordable template layer **(D)** and on this layer additionally
a peelable protective film or cover film **(El)**.

4. The recording element according to one of the preceding claims, **characterized in that** the recordable or imaged template layer **(D, Da)** has a layer thickness of 1 µm to 50 µm, preferably from 3 µm to 30 µm.

5. The recording element according to one of the preceding claims, **characterized in that** the recordable template layer **(D)** can be exposed with actinic laser radiation of a power of 10 to 1500 mJ/cm² in the spectral range from 330 nm to 430 nm, in particular from 50 to 1000 mJ/cm² in the specified spectral range.

6. The recording element according to one of the preceding claims, **characterized in that** the recordable template layer can be developed by means of an alkaline solution or alkaline vapors, like ammonia vapor, such that the unexposed areas become less permeable to actinic radiation, in particular such that the unexposed, developed areas of the recordable template layer have an actinic density > 3.0.

7. The recording element according to one of the preceding claims, **characterized in that** the recordable template layer consists of at least 70 % by weight, in particular at least 85 % by weight of a mixture of at least one cellulose ester-based binder and a diazonium compound and a reactive coupler compound, wherein
the diazonium compound is a diazonium salt according to formula (I),
**R-N≡N⁺X⁻** **(I)**
**wherein R** is a substituted or unsubstituted organic group such as an alkyl group, acyl group or aromatic group,
**X⁻** is an anion, in particular selected from the group comprising BF₄⁻, AsF₆⁻, ClO₄⁻, SbF₆⁻, CF₃SO₃⁻, SO₄⁻,PF₆⁻ PO₄³⁻, NO₃⁻, Br⁻, Cl⁻, I⁻, F⁻, arylsulfonate, such as p-chlorobenzenesulfonate, alkylsulfonate, , allylsulfonate, or a metal complex anion, e.g. ZnCl₃⁻, SnCl₆²⁻,
and the reactive coupler compound is in particular a coupler compound of **formula (II),** 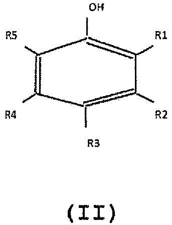
wherein **R1, R2, R3, R4 and R5** may be the same or different and are selected from the group comprising - OH, -SO₃H, -CONH-R6 (R6 = alkyl, aryl, cycloalkyl, alkoxy), alkoxy group, carboxy group, guanidine group, amino group, acylamido group, thiourea group, thio group, hydrogen or halogen, or
**R1 and R2** or **R2 and R3** together form a butadienyl group,
and wherein the ratio of binder to diazo compound usually is from 50 : 1 to 1 : 2, preferably from 20 : 1 to 1 : 1, and the ratio of diazo compound to coupler compound from 4 : 1 to 1 : 4, preferably from 2 : 1 to 1 : 2.

8. The recording element according to one of the preceding claims, **characterized in that**
the actinic radiation transparen intermediate layer **(C)** or the actinic radiation transparent intermediate film **(C)** has a thickness of up to 200 µm, such as 0.5 µm to 200 µm, preferably from 1 µm to 100 µm, in particular of 2 µm to 50 µm, more preferably from 3 µm to 15 µm.

9. The recording element according to one of the preceding claims, **characterized in that** it comprises an actinic radiation transparent intermediate layer (C) that consists of at least 70 % by weight, preferably at least 85 % by weight of at least one binder which is based on at least one water-soluble and/or organic solvent-soluble polymer or copolymer and can be removed by water and/or solvent, like polyvinyl alcohols, partially or highly hydrolyzed (highly saponified) polyvinyl carboxylates, polyvinyl acetates, poly(ethylene oxide-vinyl alcohol) copolymers or poly(ethylene oxide-vinyl alcohol) copolymers, polyvinyl butyral, polyurethane, polyvinylpyrrolidone, gelatin or mixtures thereof, in particular polymers from the group consisting of polyvinyl alcohol, polyvinylpyrrolidone, polyamide, polyurethane, gelatin and mixtures thereof

10. The recording element according to one of the preceding claims, **characterized in that** it comprises an actinic radiation transparent intermediate film **(C),** which may be mechanically removed from the relief layer **(B),** in particular peeled off, in particular an intermediate film **(C)** selected from the group consisting of polymer films like polyester, such as polyethylene terephthalate (PET), polybutylene terephthalate (PBT), polyethylene naphthalate (PEN) and polymethyl methacrylate (PMMA), polyamide or polycarbonate or polyolefins, such as polyethylene (PΞ), polypropylene (PP), polymethylpentene (PMP) and polybutylene (PB, PIB) or fluoropolymers, such as tetrafluoroethylene (PTFE), polyvinylidene fluoride (PVDF), ethylene tetrafluoroethylene (ETFE), polyvinyl fluoride (PVF) and perfuoroethylene propylene (PEP, FEP) or polyaryl sulfones, such as polysulfone (PSU) and polyethersulfone (PES), in particular PET films.

11. The recording element according to one of the preceding claims, **characterized in that** the relief layer (B) has a layer thickness of 200 µm to 8000 µm, in particular 300 µm to 6000 µm and/or comprises or consists of at least one elastomeric binder, at least two ethylenically unsaturated copolymerizable organic compounds (monomers) and a photoinitiator or a photoinitiator system.

12. A semi-finished product for producing a recording element of any one of claims 1 to 11, **characterized in that** it contains or consists of the following layers:
**(C)** an actinic radiation transparent intermediate layer or an actinic radiation transparent intermediate film
**(D)** a recordable template layer comprising a monomeric diazonium compound which is photosensitive to actinic laser radiation and undergoes a change in actinic density by development, ***or***
**(Da)** an imaged template layer wherein the monomeric diazonium compound is destroyed in at least one area by actinic laser radiation, and has an increased actinic density in at least one unexposed area due to development.

13. The semi-finished product according to claim 12, **characterized in that** it comprises
on the recordable template layer **(D)** a peelable protective film or cover film **(E1)**
and/or on the actinic radiation transparent intermediate layer **(C)** or on the actinic radiation transparent intermediate film **(C),** in particular on the actinic radiation transparent intermediate layer **(C),** a peelable protective film or cover film **(E2).**

14. Method for the production of a recording element according to one of claims 1 to 11 using a semi-finished product according to claim 12 or 13 and a flexographic printing element comprising a carrier film **(A),** a relief layer **(B),** optionally an adhesive layer between the relief layer **(B)** and the carrier film **(A)** and optionally a peelable protective film or cover film **(E3)** on the relief layer **(B), characterized in that** it comprises the following steps:
(i) removing optionally present protective films or cover films **(E2), (E3)** from the actinic radiation transparent intermediate layer **(C)** or actinic radiation transparent intermediate film **(C)** and from the relief layer **(B)** of the flexographic printing element,
(ii) optionally removing a protective film or cover film **(El)** from the recordable template layer **(D),**
(iii) optionally imaging the recordable template layer **(D)** by exposing and developing,
(iv) transferring and laminating the recordable template layer **(D)** or the imaged template layer **(Da)** on the actinic radiation transparent intermediate layer **(C)** or on the actinic radiation transparent intermediate film **(C)** onto the relief layer **(B)** of the flexographic printing element ***or*** removing the actinic radiation transparent intermediate layer **(C)** or the actinic radiation transparent intermediate film **(C)** and transfering the imaged template layer **{Da)** onto the relief layer **(B)** of the flexographic printing element.

15. Method for producing high-resolution flexographic printing plates by using a recording element according to one of claims 1 to 11 and by imaging by means of digital information transmission using actinic laser radiation, **characterized in that** it comprises the following process steps:
**(1)** optionally **peeling off** the cover film **(E1)**,
**(2) exposing** the recordable template layer **(D)** by means of actinic laser radiation to form an exposed template layer,
**(3) developing** the exposed template layer to form an imaged template layer **(Da),**
**(4) exposing** the recording element provided with the imaged template layer **(Da)** with actinic radiation through the imaged template layer,
**(5) removing** the template layer **(Da),** the optionally present intermediate layer **(C)** as well as the not polymerized portions of the relief-forming layer **(B)** to form the flexographic printing plate,
**(6) drying** the obtained flexographic printing plate and
**(7)** optionally and preferably **after-treating** the flexographic printing plate with UV light.

16. Method for producing high-resolution flexographic printing plates by using a semi-finished product according to claim 12 or 13 and by imaging by means of digital information transmission using actinic laser radiation, **characterized in that** it comprises the following process steps:
**(i)** optionally **peeling off** the cover film **(El)** from the semi-finished product,
**(ii) exposing** the recordable template layer **(D)** on the actinic radiation transparent intermediate layer **(C)** or the actinic radiation transparent intermediate film **(C)** by means of actinic laser radiation to form an exposed template layer,
**(iii) developing** the exposed template layer to form an imaged template layer **(Da),**
**(iv)** optionally **peeling off** a protection film or cover film **(E2)** possibly present on the transparent intermediate layer or intermediate film **(C)**
**(v) transferring and laminating** the imaged template layer (Da) on the transparent intermediate layer or intermediate film **(C) or** the imaged template layer **(Da)** onto the relief layer **(B)** of a flexographic printing element comprising this relief layer **(B),** a carrier film **(A)** and optionally an adhesive layer between the relief layer **(B)** and the carrier film **(A)** to form an imaged recording element,
**(vi) exposing** the imaged recording element to actinic radiation through the imaged template layer **(Da),**
**(vii) removing** the template layer **(Da),** optionally the intermediate layer or intermediate film **(C)** and the not polymerized portions of the relief layer **(B)** to form the flexographic printing plate,
**(viii) drying** the obtained flexographic printing plate
**(ix)** optionally and preferably after-treating the flexographic printing plate with UV light.

17. Method according to one of claims 14 to 16, **characterized in that** the actinic radiation recordable layer **(D)** is exposed to actinic laser radiation of 10 to 1500 mJ/cm² in the spectral range of 330 nm to 430 nm, in particular from 50 bis 1000 mJ/cm² in the specified spectral range.

18. Method according to one of claims 14 to 17, **characterized in that** the recordable template layer is developed after exposure by using an alkaline solution or an alkaline vapor, in particular ammonia vapor.

19. Method according to one of Claims 15 to 18, **characterized in that** the relief layer **(B)** is exposed to actinic radiation of > 5 to 100 J/cm² in the spectral range from 200 nm to 450 nm through the imaged template layer **(Da)** and, if appropriate, the actinic radiation transparent intermediate layer or intermediate film **(C).**

20. Method according to one of claims 15 to 19, **characterized in that**
(i) the template layer **(Da),** the intermediate layer (C) and the not polymerized parts of the relief layer **(B)** are removed by means of a leaching agent which contains or consists of water and/or solvent, ***or*** that
(ii) the intermediate film **(C)** is peeled off together with the template layer **(Da)** and the not polymerized parts of the relief layer **(B)** are removed by means of a leaching agent containing or consisting of water and/or solvent.

21. Use of a recordable template layer comprising a monomeric diazonium compound which is photosensitive to actinic laser radiation and undergoes a change in the actinic density by developing, for the production of flexographic printing plates, in particular by means of a semi-finished product according to one of claims 12 or 13 or for producing a recording element according to one of claims 1 to 11, or in a semi-finished product according to one of claims 12 or 13 or in a recording element according to one of claims 1 to 11.

## Revendications

1. Elément imprimable adapté à la fabrication de plaques d'impression flexographiques à haute résolution par transfert numérique d'informations et imprimable ou imprimé par un rayonnement laser actinique et qui, disposées les uns au-dessus des autres dans l'ordre mentionné, contient ou est constitué des couches suivantes:
**(A)** un film support qui peut optionnellement être muni d'une couche adhésive sur le côté muni d'une couche photopolymérisable/couche en relief,
**(B)** une couche photopolymérisable/couche de relief qui est soluble dans des solvants organiques et/ou aqueux et réticulables par rayonnement actinique,
**(D)** une couche modèle imprimable comprenant un composé monomère de diazonium qui est photosensible au rayonnement laser actinique et qui subit un changement de densité actinique par développement, ou
**(Da)** une couche modèle imprimée dans laquelle le composé monomère de diazonium est détruit dans au moins une région par un rayonnement laser actinique et présente une densité actinique accrue dans au moins une région non exposée à cause du développement.

2. L'élément imprimable selon la revendication 1, **caractérisé en ce qu'**une couche **(C)** est disposée entre les couches **(B)** et **(D),** la couche
**(C)** étant une couche intermédiaire transparente au rayonnement actinique comme élément de séparation.

3. L'élément imprimable selon la revendication 1 ou 2, **caractérisé en ce qu'**il comprend
la couche modèle imprimable **(D)** et, sur cette couche, en outre
un film protecteur ou de recouvrement pelable **(El)** .

4. L'élément imprimable selon l'une des revendications précédentes, **caractérisé en ce que** la couche modèle imprimable ou imprimée **(D, Da)** a une épaisseur de couche de 1 µm à 50 µm, de préférence de 3 µm à 30 µm.

5. L'élément imprimable selon l'une des revendications précédentes, **caractérisé en ce que** la couche modèle imprimable **(D)** peut être exposée à un rayonnement laser actinique d'une puissance de 10 à 1500 mJ/cm² dans le domaine spectral de 330 nm à 430 nm, en particulier de 50 à 1000 mJ/cm² dans le domaine spectral indiqué.

6. L'élément imprimable selon l'une des revendications précédentes, **caractérisé en ce que** la couche modèle imprimable peut être développée au moyen d'une solution alcaline ou de vapeurs alcalines, telles que la vapeur d'ammoniac, de telle sorte que les zones non exposées deviennent moins perméables au rayonnement actinique, notamment de telle sorte que les zones non exposées et développées de la couche modèle imprimable ont une densité actinique > 3,0.

7. L'élément imprimable selon l'une des revendications précédentes, **caractérisé en ce que** la couche modèle imprimable est constituée d'au moins 70 % en poids, en particulier d'au moins 85 % en poids, d'un mélange d'au moins un liant à base d'ester de cellulose et un composé de diazonium et un composé de couplage réactif, où
le composé de diazonium est un sel de diazonium selon la formule **(I),**
**R-N≡N⁺X⁻** **(I)**
R représentant un groupe organique substitué ou non substitué tel qu'un groupe alkyle, acyle ou aromatique, et
**X⁻** étant un anion, en particulier choisi dans le groupe comprenant BF₄⁻, AsF₆⁻, ClO₄⁻, SbF₆⁻, CF₃SO₃⁻, SO₄⁻,PF₆⁻ PO₄³⁻, NO₃⁻, Br⁻, Cl⁻,I⁻,F⁻, Arylsulfonate, comme le p-chlorobenzène sulfonate, alkyl sulfonate, allylsulfonate ou un anion complexe métallique z.B. ZnCl₃⁻, SnCl₆²⁻.
et le composé coupleur réactif, en particulier étant un composé coupleur de formule **(II),** 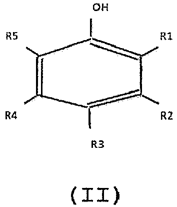
**R1, R2, R3, R4 et R5** pouvant être identiques ou différents et étant choisis dans le groupe constitué par -OH, -SO3H, -CONH-R6 (R6=alkyle-, aryle-, cycloalkyle, alcoxy), groupe alcoxy, groupe carboxy, groupe guanidine, groupe amino, groupe acylamido, groupe thiourée, groupe thio, hydrogène ou halogène, ou
**R1 et R2** ou **R2 et R3** formant ensemble un radical butadiényle,
et le rapport du liant au composé diazoïque étant généralement de 50 : 1 à 1 : 2, de préférence de 20 : 1 à 1 : 1 et le rapport du composé diazoïque au composé coupleur étant de 4 : 1 à 1 : 4, de préférence de 2 : 1 à 1 : 2.

8. L'élément imprimable selon l'une des revendications précédentes, **caractérisé en ce que**
la couche intermédiaire **(C)** transparente au rayonnement actinique ou le film intermédiaire **(C)** transparent au rayonnement actinique a une épaisseur jusqu'à 200 µm, telle que 0,5 µm à 200 µm, de préférence de 1 µm à 100 µm, en particulier de 2 µm à 50 µm, particulièrement préféré de 3 µm à 15 µm.

9. L'élément imprimable selon l'une des revendications précédentes, **caractérisé en ce qu'**il comprend une couche intermédiaire **(C)** transparente au rayonnement actinique et cosistant au moins 70% en poids, notamment au moins 85% en poids, d'un liant à base d'au moins un polymère ou copolymère soluble dans l'eau et/ou un solvant organique, qui peut être éliminé par l'eau et/ou un solvant comme les poly(alcools vinyliques), les poly(carboxylates de vinyle) partiellement ou fortement saponifiés, les polyvi-nylacetates, copolymères de poly(oxyde d'éthylène-alcool vinylique) ou de poly(oxyde d'éthylène-alcool vinylique), polyvinylbutyral, polyuréthane, polyvinylpyrrolidone, gélatine ou leurs mélanges, en particulier polymères du groupe constitué par l'alcool polyvinylique, polyvinypyrrolidone, polyamide, polyuréthane et gélatine ou leurs mélanges.

10. L'élément imprimable selon l'une des revendications précédentes, **caractérisé en ce qu'**il comprend un film intermédiaire **(C)** transparent au rayonnement actinique qui peut être enlevé mécaniquement, particulièrement retiré, de la couche en relief **(B),** en particulier un film intermédiaire **(C),** qui est choisi dans le groupe constitué des films polymères, tels que des polyesters, par exemple le polyéthylène téréphtalate (PET), le polybutylène téréphtalate (PBT), le polyéthylène naphtalate (PEN) et le polyméthacrylate de méthyle (PMMA), le polyamide ou le polycarbonate, ou les polyoléfines comme le polyéthylène (PE), le polypropylène (PP), le polyméthylène pentène (PMP) et le polybutylène (PB, PIB) ou des polymères fluorés, tels que le tétrafluoroéthylène (PTFE), le poly(fluorure de vinylidène) (PVDF), l'éthylènetrafluoroéthylène (ETFE), le poly(fluorure de vinyle) (PVF) et le perfluoroéthylène propylène (PEP, FEP) ou des polyarylsufons, comme le polysulfone (PSU) et le polyéthersulfone (PES), notamment des films PET.

11. L'élément imprimable selon l'une des revendications précédentes, **caractérisé en ce que** la couche en relief **(B)** présente une épaisseur de couche de 200 µm à 8000 µm, en particulier de 300 µm à 6000 µm, et/ou contient ou consiste en au moins un liant élastomère, au moins deux composés organiques (monomères) copolymérisables à insaturation éthylénique et un photoinitiateur ou un système photoinitiateur.

12. Produit semi-fini pour la fabrication d'un élément imprimable selon l'une des revendications 1 à 11, **caractérisé en ce qu'**il contient ou est constitué des couches suivantes:
**(C)** une couche intermédiaire transparente au rayonnement actinique ou un film intermédiaire transparent au rayonnement actinique,
**(D)** une couche modèle imprimable comprenant un composé monomère de diazonium qui est photosensible au rayonnement laser actinique et qui subit un changement de densité actinique par développement, ***ou***
**(Da)** une couche modèle imprimée dans laquelle le composé monomère de diazonium est détruit dans au moins une région par un rayonnement laser actinique et présente, par développement, une densité actinique accrue dans au moins une région non exposée.

13. Le produit semi-fini selon la revendication 12, **caractérisé en ce qu'**il a
sur la couche modèle imprimable **(D),** un film protecteur ou de recouvrement pelable **(El)**
et/ou sur la couche intermédiaire **(C)** transparente au rayonnement actinique ou sur le film intermédiaire **(C)** transparent au rayonnement actinique, en particulier sur la couche intermédiaire **(C)** transparente au rayonnement actinique, un film protecteur ou de recouvrement pelable **(E2).**

14. Procédé de fabrication d'un élément imprimable selon l'une des revendications 1 à 11, en utilisant un produit semi-fini selon la revendication 12 ou 13 et un élément d'impression flexographique comprenant un film support **(A),** une couche en relief **(B),** éventuellement une couche adhésive entre la couche en relief **(B)** et le film support **(A)** et éventuellement un film protecteur ou de recouvrement pelable **(E3)** sur la couche en relief **(B), caractérisé en ce qu'**il comporte les étapes suivantes:
(i) enlever tout film protecteur ou de recouvrement **(E2), (E3)** de la couche intermédiaire **(C)** transparente au rayonnement actinique ou de l'élément intermédiaire **(C)** transparent au rayonnement actinique et de la couche en relief **(B)** de l'élément flexographique,
ii) si nécessaire, enlever un film de protection ou de recouvrement **(El)** de la couche modèle imprimable **(D),**
iii) si nécessaire, représenter la couche modèle imprimable **(D)** par exposition et développement, (iv) transférer et laminer la couche modèle imprimable **(D)** ou la couche modèle imprimée **(Da)** sur la couche en relief **(B)** de l'élément d'impression flexographique ou retirer la couche intermédiaire **(C)** transparente à rayonnement actinique **ou** le film intermédiaire **(C)** transparent à rayonnement actinique et transférer la couche modèle imprimée **(Da)** sur la couche en relief **(B)** de l'élément d'impression flexographique.

15. Procédé de fabrication de plaques d'impression flexographiques à haute résolution utilisant un élément imprimable selon l'une quelconque des revendications 1 à 11 et une formation d'image par transfert numérique d'informations en utilisant un rayonnement laser actinique, **caractérisé en ce qu'**il comprend les étapes suivantes du procédé:
**(1)** le cas échéant, **décoller** le film de recouvrement **(E1),**
**(2) exposer** la couche modèle imprimable **(D)** au moyen d'un rayonnement laser actinique pour former une couche modèle exposée,
**(3) développer** la couche modèle exposée en formant une couche modèle imprimée **(Da),**
**(4) exposer** l'élément imprimable fourni avec la couche modèle imprimée **(Da)** à un rayonnement actinique à travers la couche modèle imprimée **(Da),**
**(5) enlever** la couche modèle **(Da),** toute couche intermédiaire **(C)** présente et les parties non polymérisées de la couche formant le relief **(B)** en formant la plaque d'impression flexographique,
**(6) sécher** la plaque d'impression flexographique obtenue et
**(7)** si nécessaire et de préférence **post-traiter** la plaque d'impression flexographique avec de la lumière UV.

16. Procédé de fabrication de plaques d'impression flexographiques à haute résolution utilisant un produit semi-fini selon la revendication 12 ou 13 et de formation d'image par transmission numérique d'informations par rayonnement laser actinique, **caractérisé en ce qu'**il comprend les étapes suivantes du procédé:
**(i)** le cas échéant, **enlever** le film de recouvrement **(El)** du produit semi-fini,
**(ii) exposer** la couche modèle imprimable **(D)** sur la couche intermédiaire transparente au rayonnement actinique **(C)** ou sur le film intermédiaire transparent au rayonnement actinique **(C)** par rayonnement laser actinique en formant une couche modèle exposée,
**(iii) développer** la couche modèle exposée en formant une couche modèle imprimée **(Da),**
**(iv)** si nécessaire, **enlever** tout film protecteur ou de recouvrement **(E2)** éventuellement présent sur la couche intermédiaire transparente ou la couche intermédiaire transparente (C)
**(v) transférer et laminer** la couche modèle imprimée **(Da)** sur la couche ou le film intermédiaire transparent **(C) ou** de la couche modèle imprimée **(Da)** sur la couche en relief **(B)** d'un élément d'impression flexographique comprenant ladite couche en relief **(B),** un film support **(A)** et éventuellement une couche adhésive entre la couche en relief **(B)** et le film support **(A)** en formant un élément d'enregistrement imprimé,
**(vi) exposer** l'élément d'enregistrement imprimé à un rayonnement actinique à travers la couche modèle imprimée **(Da).**
**(vii) enlever** la couche modèle **(Da),** éventuellement la couche le film intermédiaire ou **(C),** et les parties non polymérisées de la couche en relief **(B)** en formant la plaque d'impression flexographique,
**(viii) sécher** la plaque d'impression flexographique obtenue
**(ix)** éventuellement et de préférence post-traiter de la plaque d'impression flexographique avec de la lumière UV.

17. Procédé selon l'une des revendications 14 à 16, **caractérisé en ce que** la couche modèle imprimable **(D)** par rayonnement actinique est exposée à un rayonnement laser actinique de 10 à 1500 mJ/cm² dans le domaine spectral de 330 nm à 430 nm, en particulier de 50 à 1 000 mJ/cm² dans le domaine spectral spécifié.

18. Procédé selon l'une des revendications 14 à 17, **caractérisé en ce que** la couche imprimable est développée après exposition avec une solution alcaline ou une vapeur alcaline, en particulier de l'ammoniac.

19. Procédé selon l'une des revendications 15 à 18, **caractérisé en ce que** la couche en relief **(B)** est exposée à travers la couche modèle imprimable **(Da)** et, si nécessaire, la couche ou le film intermédiaire **(C)** transparent au rayonnement actinique avec un rayonnement actinique > 5 à 100 J/cm2 dans le domaine spectral de 200 nm à 450 nm.

20. Procédé selon l'une des revendications 15 à 19, **caractérisé en ce que**
(i) la couche modèle **(Da),** la couche intermédiaire **(C)** et les parties non polymérisées de la couche en relief **(B)** sont éliminées au moyen d'un agent de lavage contenant de l'eau et/ou un solvant ou consistant en de l'eau et/ou un solvant, ***ou* en ce que**
(ii) le film intermédiaire **(C)** est retiré avec la couche modèle **(Da)** et les parties non polymérisées de la couche en relief **(B)** sont éliminées au moyen d'un agent de lavage contenant de l'eau et/ou un solvant ou consistant en eau et/ou un solvant.

21. Utilisation d'une couche modèle imprimable comprenant un composé monomère de diazonium sensible à la lumière d'un rayonnement laser actinique et qui subit un changement de densité actinique par développement, pour la fabrication de plaques d'impression flexographiques, en particulier au moyen d'un produit semi-fini selon l'une des revendications 12 ou 13, ou pour la fabrication d'un élément imprimé selon l'une des revendications 1 à 11, ou dans un produit semi-fini selon l'une des revendications 12 ou 13, ou dans un élément imprimable selon l'une des revendications 1 à 11.
